(19) Europäisches Patentamt
European Patent Office
Office européen des brevets

(11) **EP 3 124 987 B1**

(12) **EUROPEAN PATENT SPECIFICATION**

(45) Date of publication and mention of the grant of the patent:
**21.11.2018 Bulletin 2018/47**

(21) Application number: **14887371.4**

(22) Date of filing: **26.03.2014**

(51) Int Cl.:
*G01R 31/36* (2006.01)    *G01R 27/02* (2006.01)
*H01M 10/48* (2006.01)    *H02J 7/00* (2006.01)
*H01M 8/04537* (2016.01)

(86) International application number:
**PCT/JP2014/058529**

(87) International publication number:
**WO 2015/145615 (01.10.2015 Gazette 2015/39)**

(54) **IMPEDANCE MEASUREMENT DEVICE AND IMPEDANCE MEASUREMENT METHOD**

IMPEDANZMESSVORRICHTUNG UND IMPEDANZMESSVERFAHREN

DISPOSITIF ET PROCÉDÉ DE MESURE D'IMPÉDANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.02.2017 Bulletin 2017/05**

(73) Proprietor: **NISSAN MOTOR CO., LTD.**
**Yokohama-shi, Kanagawa 221-0023 (JP)**

(72) Inventors:
• **SAKAI, Masanobu**
**Atsugi-shi**
**Kanagawa 243-0123 (JP)**
• **MATSUMOTO, Michihiko**
**Atsugi-shi**
**Kanagawa 243-0123 (JP)**

• **AOKI, Tetsuya**
**Atsugi-shi**
**Kanagawa 243-0123 (JP)**

(74) Representative: **Grünecker Patent- und Rechtsanwälte**
**PartG mbB**
**Leopoldstraße 4**
**80802 München (DE)**

(56) References cited:
**EP-A1- 2 650 689      WO-A1-2012/077450**
**JP-A- H02 287 163      JP-A- H06 242 157**
**JP-A- 2002 257 876      JP-A- 2005 180 927**
**JP-A- 2005 180 927      JP-A- 2012 163 510**
**US-A1- 2011 031 048    US-A1- 2012 306 506**
**US-A1- 2013 026 994**

**Description**

TECHNICAL FIELD

This invention relates to an impedance measuring device and an impedance measuring method for measuring an impedance of a laminated battery.

BACKGROUND ART

A device for measuring an internal resistance of a laminated battery with power supplied to a load from the laminated battery is proposed in WO2012077450.

This measuring device outputs an alternating current of the same frequency to each of a positive electrode terminal and a negative electrode terminal of the laminated battery such that no current leaks to the load from the laminated battery. The measuring device detects an alternating-current potential difference obtained by subtracting a potential at an intermediate-point terminal located between the positive electrode terminal and the negative electrode terminal from a potential of the positive electrode terminal of the laminated battery and an alternating-current potential difference obtained by subtracting the potential of the intermediate-point terminal from a potential of the negative electrode terminal. The internal resistance of the laminated battery is measured on the basis of the detected alternating-current potential differences and the output alternating currents.

Reference JP 2005/180927 (A) discloses an impedance-measuring instrument for measuring the impedance of a measuring object, such as a fuel cell, while removing the effect of a measurement system. The impedance-measuring instrument is equipped with a load device for generating an input signal which is a pulse wave containing frequencies in a band necessary for measurement, a standard element with a known impedance, a switching circuit for switchably connecting the load device to either the measuring object or the standard element, and a calculation part for calculating the impedance of the measuring object based on a first response signal, obtained when connecting the measuring object to the load device to give thereto the input signal and on a second response signal, obtained when connecting the standard element to the load device to give thereto the input signal.

Reference US 2012/306506 (A1) discloses a voltage monitoring system with a voltage monitoring module which includes an adjusting current control circuit to generate an adjusting current so that the operating current consumed by the voltage monitoring modules reaches a specified value corresponding to a first operation current setting command, and stops generating the adjusting current according to an operating current switching command. An operating current measurement circuit measures the operating current according to the operating current measuring command following the operating current switching command. A module control circuit sends a second operation current setting command based on the operating current that was measured, and the adjusting current control circuit generates an adjusting current so that the operating current reaches a specified value corresponding to the second operating current setting command.

In the measuring device described above, electronic components such as operational amplifiers are used as a component for outputting an alternating current as an analog signal, a component for detecting the alternating-current potential differences and the like. Thus, accuracy in measuring the impedance of the laminated battery may be reduced due to manufacturing variations of the electronic components, deterioration with time, an output variation associated with a temperature increase and the like.

The present invention was developed in view of such a problem and aims to provide an impedance measuring device designed to maintain and improve reliability for a measurement result as against a reduction of measurement accuracy due to electronic components.

This is achieved by the features of the independent claims. Preferred embodiments are the subject matter of the dependent claims.

BRIEF DESCRIPTION OF DRAWINGS

FIG. 1A is a view showing an example of a laminated battery as a measurement object of an impedance measuring device in a first embodiment of the present invention,
FIG. 1B is an exploded view showing the structure of a battery cell formed in the laminated battery,
FIG. 2 is a diagram showing a basic configuration of the impedance measuring device in the present embodiment,
FIG. 3 is a diagram showing direct current shut-off units and potential difference detection units,
FIG. 4 is a diagram showing power supply units for outputting alternating currents to a positive electrode and a negative electrode of the laminated battery,

FIG. 5 is a view showing the detail of an alternating current adjustment unit for adjusting the alternating currents output to the positive electrode and the negative electrode of the laminated battery,

FIG. 6 is a diagram showing the detail of a computation unit for computing an internal impedance of the laminated battery,

FIG. 7 is a flow chart showing an example of an equipotential control method for controlling potentials generated on the positive electrode and the negative electrode of the laminated battery equally to each other,

FIGS. 8 are time charts when a controller executes an equipotential control,

FIG. 9 is a chart showing potentials generated at the positive electrode and the negative electrode of the laminated battery by the equipotential control,

FIG. 10 is a diagram showing a detailed configuration of the impedance measuring device in the present embodiment,

FIG. 11 is a diagram showing a connection state in the impedance measuring device when a measurement state of the laminated battery is diagnosed,

FIG. 12 is a flow chart showing an example of an impedance measuring method in the present embodiment,

FIG. 13 is a diagram showing a detailed configuration of an impedance measuring device in a second embodiment of the present invention,

FIG. 14 is a diagram showing a connection state when a resistance of a second diagnosis element is measured in the impedance measuring device,

FIG. 15 is a diagram showing an example of a connection state for measuring a measurement error caused in a measurement path on a negative electrode side in the impedance measuring device,

FIG. 16 is a graph showing an example of a correction technique for correcting a measurement value of an internal resistance of a laminated battery, and

FIG. 17 is a flow chart showing an example of an impedance measuring method in the present embodiment.

## DESCRIPTION OF EMBODIMENTS

Hereinafter, embodiments of the present invention are described with reference to the accompanying drawings.

(First Embodiment)

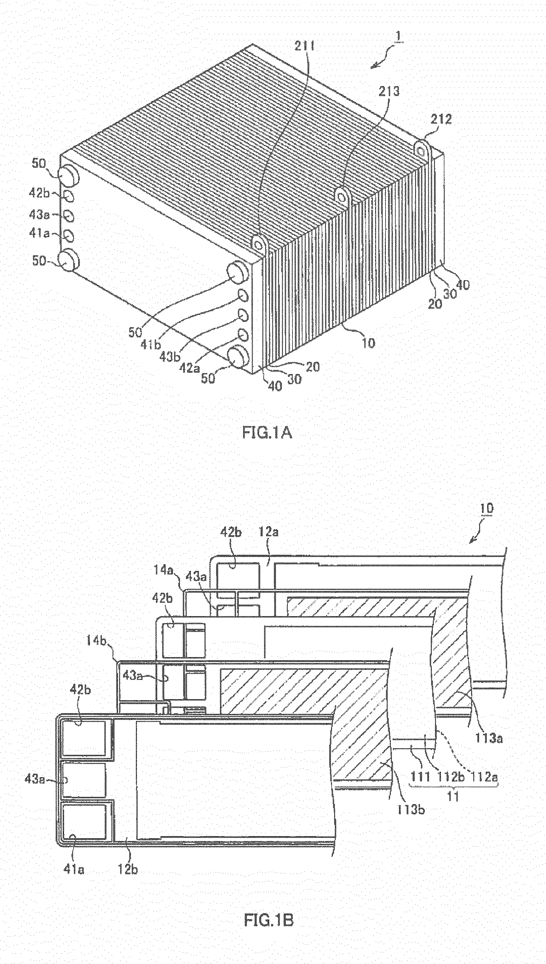

FIG. 1A is a view showing an example of a laminated battery as a measurement object to be measured by an impedance measuring device in a first embodiment of the present invention. An external perspective view of a fuel cell stack 1, in which a plurality of battery cells are laminated, as an example of a laminated battery is shown in FIG. 1A.

As shown in FIG. 1A, the fuel cell stack 1 includes a plurality of power generation cells 10, current collector plates 20, insulation plates 30, end plates 40 and four tension rods 50.

The power generation cell 10 is a so-called battery cell and indicates one of a plurality of fuel cells laminated in the fuel cell stack 1. The power generation cell 10 generates an electromotive voltage of about 1 V (volt). The detailed configuration of the power generation cell 10 is described later with reference to FIG. 1B.

The current collector plates 20 are respectively arranged at outer sides of the laminated power generation cells 10. The current collector plates 20 are formed of a gas-impermeable conductive material such as dense carbon. The current collector plates 20 include a positive electrode terminal 211 and a negative electrode terminal 212. It should be noted that electrons e generated in the power generation cells 10 are extracted from the negative electrode terminal 212.

Further, an intermediate-point terminal 213 is provided between the positive electrode terminal 211 and the negative electrode terminal 212. The intermediate-point terminal 213 is connected to the power generation cell 10 located in the middle out of a plurality of power generation cells 10 laminated from the positive electrode terminal 211 to the negative electrode terminal 212. It should be noted that the intermediate-point terminal 213 may be located at a position deviated from a middle point between the positive electrode terminal 211 and the negative electrode terminal 212.

The insulation plates 30 are respectively arranged at outer sides of the current collector plates 20. The insulation plates 30 are formed of an insulating material such as rubber.

The end plates 40 are respectively arranged at outer sides of the insulation plates 30. The end plates 40 are formed of a rigid metal material such as steel.

One end plate 40 (end plate 40 on a front left side in FIG. 1A) includes an anode supply port 41a, an anode discharge port 41b, a cathode supply port 42a, a cathode discharge port 42b, a cooling water supply port 43a and a cooling water discharge port 43b. In the present embodiment, the anode discharge port 41b, the cooling water discharge port 43b and the cathode supply port 42a are provided on a right side in FIG. 1A. Further, the cathode discharge port 42b, the cooling water supply port 43a and the anode supply port 41a are provided on a left side in FIG. 1A.

The tension rods 50 are respectively arranged near four corners of the end plate 40. The fuel cell stack 1 is formed with holes (not shown) penetrating inside. The tension rods 50 are inserted into these through holes. The tension rods 50 are formed of a rigid metal material such as steel. An insulation processing is applied to surfaces of the tension rods 50 to prevent an electrical short circuit between the power generation cells 10. Nuts (not shown by being located on a back side) are threadably engaged with these tension rods 50. The tension rods 50 and the nuts tighten the fuel cell stack 1 in a lamination direction.

A method for supplying hydrogen as anode gas to the anode supply port 41a is, for example, a method for directly supplying hydrogen gas from a hydrogen storage device, a method for supplying hydrogen by reforming hydrogen-containing fuel or the like. It should be noted that the hydrogen-containing fuel is natural gas, methanol, gasoline or the like. Further, air is generally used as cathode gas to be supplied to the cathode supply port 42a.

FIG. 1B is an exploded view showing the structure of the power generation cell 10 laminated in the fuel cell stack 1.

As shown in FIG. 1B, the power generation cell 10 is structured such that an anode separator (anode bipolar plate) 12a and a cathode separator (cathode bipolar plate) 12b are arranged on opposite surfaces of a membrane electrode assembly (MEA) 11.

In the MEA 11, electrode catalyst layers 112 are formed on opposite surfaces of an electrolyte membrane 111 composed of an ion-exchange membrane. Gas diffusion layers (GDLs) 113 are formed on these electrode catalyst layers 112.

The electrode catalyst layer 112 is, for example, formed of platinum-carrying carbon black particles.

The GDL 113 is, for example, formed of a material having sufficient gas diffusion property and electrical conductivity such as carbon fibers.

The anode gas supplied from the anode supply port 41a flows in this GDL 113a, reacts with the anode electrode catalyst layer 112 (112a) and is discharged from the anode discharge port 41b.

The cathode gas supplied from the cathode supply port 42a flows in this GDL 113b, reacts with the cathode electrode catalyst layer 112 (112b) and is discharged from the cathode discharge port 42b.

The anode separator 12a is laid on one surface (back surface in FIG. 1B) of the MEA 11 via the GDL 113a and a seal 14a. The cathode separator 12b is laid on one surface (front surface in FIG. 1B) of the MEA 11 via the GDL 113b and a seal 14b. The anode separator 12a and the cathode separator 12b are, for example, formed by press-molding a separator base made of metal such as stainless steel, forming reaction gas flow passages on one surface and forming cooling water flow passages on an opposite surface such that the reaction gas flow passages and the cooling water flow passages are alternately arranged. As shown in FIG. 1B, the anode separator 12a and the cathode separator 12b are laid together to form the cooling water flow passages.

The MEA 11, the anode separator 12a and the cathode separator 12b are respectively formed with holes 41a, 41b, 42a, 42b, 43a and 43b and, by laying these one next to each other, the anode supply port 41a, the anode discharge port 41b, the cathode supply port 42a, the cathode discharge port 42b, the cooling water supply port 43a and the cooling water discharge port 43b are formed.

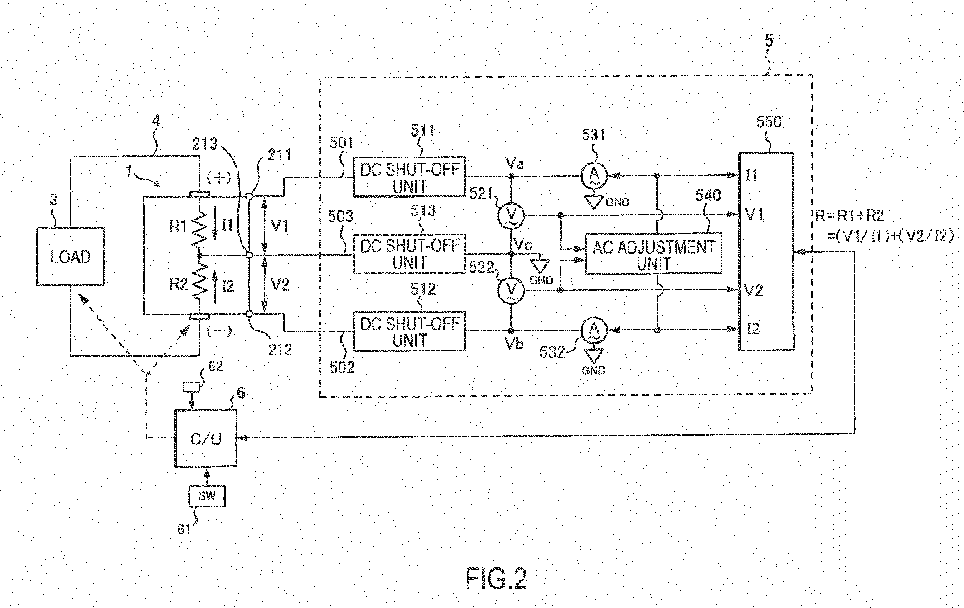

FIG. 2 is a diagram showing a basic configuration of an impedance measuring device 5 in the embodiment of the present invention.

The fuel cell stack 1 is a laminated battery connected to a load 3 for supplying power to the load 3 and, for example, mounted in a vehicle. The fuel cell stack 1 has an impedance inside. The load 3 is, for example, an electric motor, an auxiliary machine used for power generation of the fuel cell stack 1 or the like. Auxiliary machines connected to the fuel cell stack 1 include, for example, a compressor for supplying the cathode gas to the fuel cell stack 1 and a heater for heating the cooling water flowing in the fuel cell stack 1 when the fuel cell stack 1 is warmed up.

A control unit (C/U) 6 controls a state of power generation of the fuel cell stack 1, operating states such as a wet state, an internal pressure state and a temperature state and an operating state of the load 3.

For example, the control unit 6 controls the amounts of the cathode gas and the anode gas supplied to the fuel cell stack 1 according to generated power requested from the load 3. Further, in the fuel cell stack 1, power generation performance is reduced if the electrolyte membranes 11 become dry. As a measure against this, the control unit 6 adjusts gas flow rates using an internal resistance value of the fuel cell stack 1 correlated with a degree of wetness of the electrolyte membranes 111 lest the electrolyte membranes 111 should become dry or excessively wet.

It should be noted that the control unit 6 is provided with an operation switch unit 61 including a start switch of a fuel cell system, a temperature sensor 62 for detecting an ambient temperature of the fuel cell stack 1, and the like.

The impedance measuring device 5 measures an internal impedance of the fuel cell stack 1. In the present embodiment, the impedance measuring device 5 measures an internal resistance R of the fuel cell stack 1 and transmits a measurement value of the internal resistance R to the control unit 6. The control unit 6 controls a wet state of the fuel cell stack 1 on the basis of the measurement value of the internal resistance R when receiving the measurement value of the internal resistance R of the fuel cell stack 1 from the impedance measuring device 5.

The impedance measuring device 5 includes a positive-electrode side direct current shut-off unit 511, a negative-electrode side direct current shut-off unit 512, an intermediate point direct current shut-off unit 513, a positive-electrode side detection unit 521, a negative-electrode side detection unit 522, a positive-electrode side power supply unit 531, a negative-electrode side power supply unit 532, an alternating current adjustment unit 540 and a computation unit 550. It should be noted that detection means is configured by the positive-electrode side detection unit 521 and the negative-electrode side detection unit 522. Power supply means is configured by the positive-electrode side power supply unit 531 and the negative-electrode side power supply unit 532.

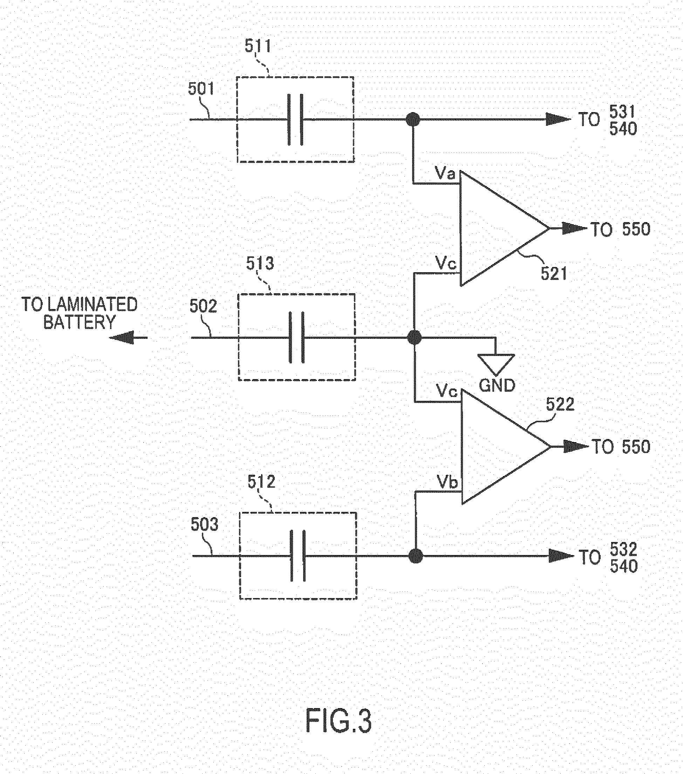

The positive-electrode side direct current shut-off unit 511, the negative-electrode side direct current shut-off unit 512, the intermediate point direct current shut-off unit 513, the positive-electrode side detection unit 521 and the negative-electrode side detection unit 522 are described in detail with reference to FIG. 3.

The positive-electrode side direct current shut-off unit 511 is connected to the positive electrode terminal 211 of the fuel cell stack 1. The negative-electrode side direct current shut-off unit 512 is connected to the negative electrode terminal 212 of the fuel cell stack 1. The intermediate point direct current shut-off unit 513 is connected to the intermediate-point terminal 213 of the fuel cell stack 1. The direct-current shut-off units 511 to 513 shut off direct-current signals, but allow alternating-current signals to flow. The direct-current shut-off units 511 to 513 are realized, for example, by capacitors or transformers. It should be noted that the intermediate point direct current shut-off unit 513 shown by broken line can be omitted.

The positive-electrode side detection unit 521 detects a potential difference between an alternating-current potential Va generated at the positive electrode terminal 211 and an alternating-current potential Vc generated at the intermediate-point terminal 213 (hereinafter, referred to as an "alternating-current potential difference V1"). The positive-electrode side detection unit 521 outputs a detection signal, whose value changes according to the fluctuation of the alternating-current potential difference V1, to the computation unit 550. For example, the value of the detection signal increases as the alternating-current potential difference V1 increases and decreases as the alternating-current potential difference V1 decreases. In the positive-electrode side detection unit 521, a first input terminal (positive-electrode side first terminal) is connected to the positive electrode terminal 211 via the positive-electrode side direct current shut-off unit 511 and a second input terminal (positive-electrode side second terminal) is connected to the intermediate-point terminal 213 via the intermediate point direct current shut-off unit 513.

The negative-electrode side detection unit 522 detects a potential difference between an alternating-current potential Vb generated at the negative electrode terminal 212 and the alternating-current potential Vc generated at the intermediate-point terminal 213 (hereinafter, referred to as an "alternating-current potential difference V2"). The negative-electrode side detection unit 522 outputs a detection signal, whose value changes according to the fluctuation of the alternating-current potential difference V2, to the computation unit 550. In the negative-electrode side detection unit 522, a first input terminal (negative-electrode side first terminal) is connected to the negative electrode terminal 212 via the negative-electrode side direct current shut-off unit 512 and a second input terminal (negative-electrode side second terminal) is connected to the intermediate-point terminal 213 via the intermediate point direct current shut-off unit 513. The positive-electrode side detection unit 521 and the negative-electrode side detection unit 522 are realized, for example, by differential amplifiers (instrumentation amplifiers).

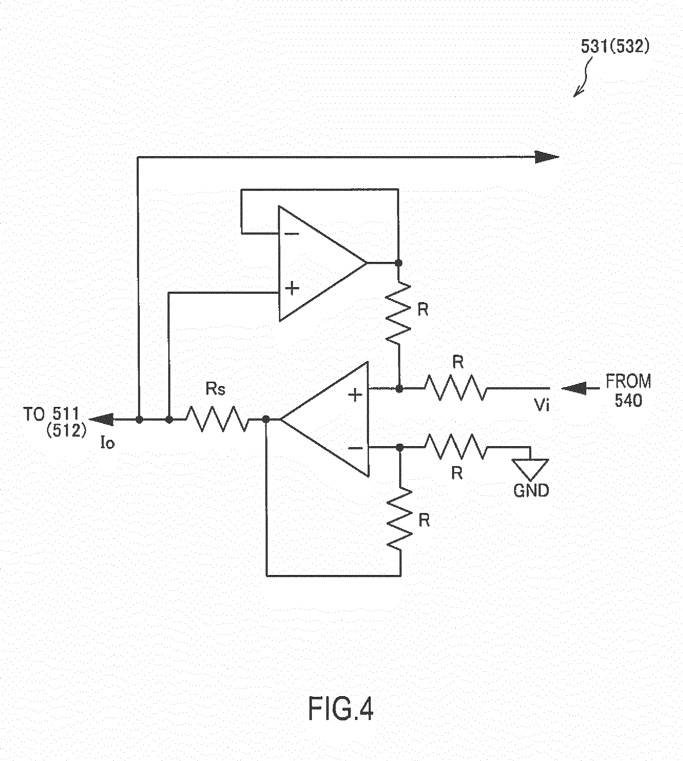

The positive-electrode side power supply unit 531 and the negative-electrode side power supply unit 532 are described in detail with reference to FIG. 4.

The positive-electrode side power supply unit 531 is a first power supply unit for outputting an alternating current of a reference frequency fb to measure an internal impedance. The positive-electrode side power supply unit 531 is realized by a voltage-current conversion circuit such as an operational amplifier (OP amplifier). By this voltage-current conversion circuit, a current Io proportional to an input voltage Vi is output. It should be noted that Io = Vi/Rs, where Rs denotes a current sensing resistance. This voltage-current conversion circuit is a variable alternating current source capable of adjusting the output current Io according to the input voltage Vi.

By using the voltage-current conversion circuit as the positive-electrode side power supply unit 531, the output current Io is obtained by dividing the input voltage Vi by a proportionality constant Rs even without actually measuring the output current Io, wherefore the output current Io can be computed if the input voltage Vi is detected. The negative-electrode side power supply unit 532 is also similarly configured. Specifically, the negative-electrode side power supply unit 532 is a second power supply unit for outputting an alternating current of the reference frequency fb.

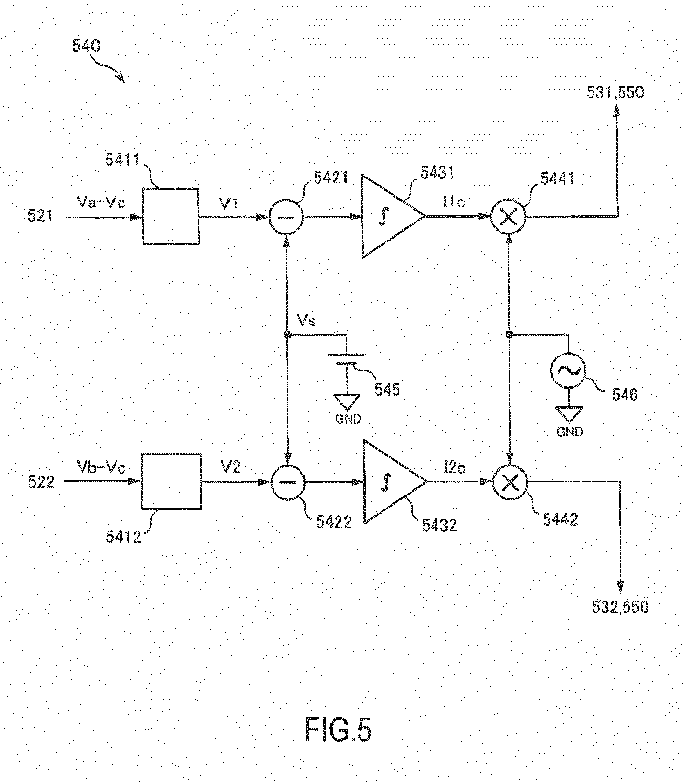

The alternating current adjustment unit 540 is described in detail with reference to FIG. 5.

The alternating current adjustment unit 540 adjusts an amplitude of the alternating current output from at least one of the positive-electrode side power supply unit 531 and the negative-electrode side power supply unit 532 such that the alternating-current potential Va on the positive electrode side and the alternating-current potential Vb on the negative electrode side coincide with each other.

In the present embodiment, the alternating current adjustment unit 540 increases and decreases both the amplitude of the alternating current output from the positive-electrode side power supply unit 531 and the amplitude of the alternating current output from the negative-electrode side power supply unit 532 such that amplitude levels of the alternating-current potential difference V1 on the positive electrode side and the alternating-current potential difference V2 on the negative electrode side become equal. The alternating current adjustment unit 540 is realized, for example, by a PI (Proportional Integral) control circuit.

Further, the alternating current adjustment unit 540 outputs command signals for the positive-electrode side power supply unit 531 and the negative-electrode side power supply unit 532 as alternating currents I1 and I2 to be output from the positive-electrode side power supply unit 531 and the negative-electrode side power supply unit 532 to the computation unit 550.

The alternating current adjustment unit 540 includes a positive-electrode side detector circuit 5411, a positive-electrode side subtractor 5421, a positive-electrode side integration circuit 5431, a positive-electrode side multiplier 5441, a negative-electrode side detector circuit 5412, a negative-electrode side subtractor 5422, a negative-electrode side integration circuit 5432 and a negative-electrode side multiplier 5442.

The alternating current adjustment unit 540 further includes a reference power supply 545 and an alternating-current signal source 546.

The reference power supply 545 outputs a potential set with 0 V (volt) as a reference (hereinafter, referred to as a "reference voltage Vs") to match the alternating-current potential difference V1 on the positive electrode side and the alternating-current potential difference V2 on the negative electrode side. The reference voltage Vs is a value determined by an experiment or the like.

The alternating-current signal source 546 is an oscillation source for oscillating an alternating-current signal of the reference frequency fb. The reference frequency fb is set at a prescribed frequency suitable to measure the internal impedance of the fuel cell stack 1. The reference frequency fb is set, for example, at 1 kHz (kilohertz).

The positive-electrode side detector circuit 5411 removes an unnecessary signal included in a detection signal when receiving the detection signal indicating the alternating-current potential difference V1 output from the positive-electrode side detection unit 521 and converts the detection signal into a direct-current signal proportional to the amplitude of the alternating-current potential difference V1. The positive-electrode side detector circuit 5411 outputs, for example, an average or effective value of the alternating-current potential difference V1 represented by the detection signal as the direct-current signal proportional to the amplitude of the alternating-current potential difference V1.

In the present embodiment, the positive-electrode side detector circuit 5411 is realized by a synchronous detector circuit. The positive-electrode side detector circuit 5411 outputs the direct-current signal corresponding to the amplitude of the alternating-current potential difference V1 by multiplying the detection signal of the alternating-current potential difference V1 by the alternating-current signal from the alternating-current signal source 546 and smoothing the resultant. Specifically, the positive-electrode side detector circuit 5411 extracts a real axis component of the alternating-current potential difference V1 from the detection signal on the basis of the alternating-current signal having the same phase as the alternating-current V1 and outputs a direct-current signal indicating that real axis component of the alternating-current potential difference V1 to the positive-electrode side subtractor 5421.

It should be noted that the positive-electrode side detector circuit 5411 may compute a vector value of the alternating-current potential difference V1 represented by the detection signal and output it to the positive-electrode side subtractor 5421. As a phase difference between the alternating-current potential differences V1 and V2 increases, the real axis component of the alternating-current potential difference V1 or V2 decreases even if the amplitudes of the alternating-current potential differences V1 and V2 are equal. Thus, the amplitude of the alternating current I1 or I2 is excessively increased or decreased by an equipotential control.

In contrast, by using the vector value, the amplitude level of the alternating-current potential difference V1 or V2 is accurately computed. Thus, the equipotential control can be properly executed.

Specifically, a square root of the sum of a square value of the real axis component of the alternating-current potential difference V1 and a square value of an imaginary axis component of the alternating-current potential difference V1 is computed to obtain the vector value of the alternating-current potential difference V1. It should be noted that the imaginary axis component of the alternating-current potential difference V1 is obtained by multiplying the detection signal of the alternating-current potential difference V1 by a signal obtained by shifting the phase of the alternating-current signal from the alternating-current signal source 546 by 90°, i.e. an orthogonal signal whose phase is orthogonal to that of the alternating current I1 and smoothing the resultant.

The positive-electrode side subtractor 5421 calculates a differential signal indicating a deviation width of the real axis component from the reference voltage Vs by subtracting the reference voltage Vs from the real axis component of the alternating-current potential difference V1 detected by the positive-electrode side detector circuit 5411. For example, a signal level of the differential signal increases as the deviation width from the reference voltage Vs increases.

The positive-electrode side integration circuit 5431 averages the differential signals or adjusts sensitivity by integrating the differential signals output from the positive-electrode side subtractor 5421. Then, the positive-electrode side integration circuit 5431 outputs the integrated differential signal to the positive-electrode side multiplier 5441.

The positive-electrode side multiplier 5441 generates an alternating-current voltage signal for converging the amplitude of the alternating-current potential difference V1 to the reference voltage Vs by multiplying the alternating-current signal of the reference frequency fb output from the alternating-current signal source 546 by the differential signal. As the signal level of the differential signal increases, the amplitude of the alternating-current voltage signal is increased by the positive-electrode side multiplier 5441.

The positive-electrode side multiplier 5441 outputs the generated alternating-current voltage signal as a command signal to the positive-electrode side power supply unit 531 shown in FIG. 4. The alternating-current voltage signal Vi input to the positive-electrode side power supply unit 531 is converted into the alternating-current signal Io and output to the positive-side electrode terminal 211 of the fuel cell stack 1 by the positive-electrode side power supply unit 531.

It should be noted that the negative-electrode side detector circuit 5412, the negative-electrode side subtractor 5422, the negative-electrode side integration circuit 5432 and the negative-electrode side multiplier 5442 are respectively basically identically configured to the positive-electrode side detector circuit 5411, the positive-electrode side subtractor 5421, the positive-electrode side integration circuit 5431 and the positive-electrode side multiplier 5441.

As just described, the alternating current adjustment unit 540 adjusts the amplitude of the alternating current I1 output from the positive-electrode side power supply unit 531 such that the amplitude of the alternating-current potential difference V1 becomes the reference voltage Vs. Similarly, the alternating current adjustment unit 540 adjusts the amplitude of the alternating current 12 output from the negative-electrode side power supply unit 532 such that the amplitude of the alternating-current potential difference V2 becomes the reference voltage Vs.

Since this causes the alternating-current potentials Va and Vb to be controlled to the same level, the alternating-current potential to be superimposed on the positive electrode terminal 211 and the alternating-current potential to be superimposed on the negative electrode terminal 212 coincide. In this way, it can be prevented that the alternating currents I1 and I2 output from the impedance measuring device 5 to the fuel cell stack 1 leak toward the load 3. It should be noted that a control of the positive-electrode side power supply unit 531 and the negative-electrode side power supply unit 532 such that the alternating-current potentials Va and Vb become equal to each other is called an "equipotential control".

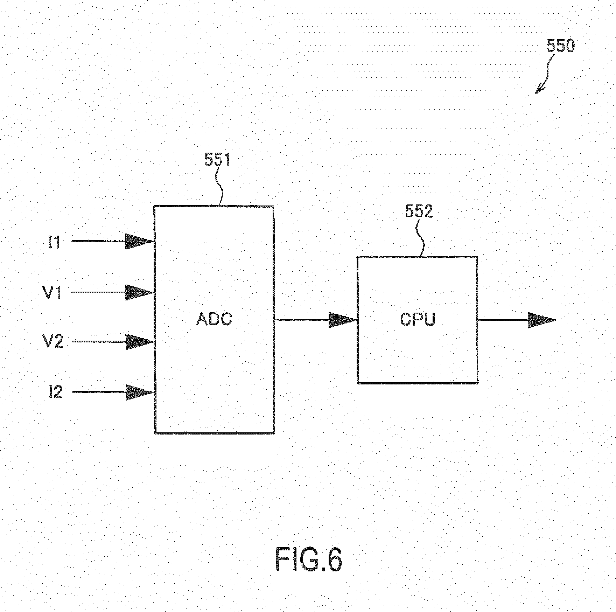

Next, the computation unit 550 is described in detail with reference to FIG. 6.

The detection signals indicating the alternating-current potential differences V1 and V2 are input to the computation unit 550 from the positive-electrode side detection unit 521 and the negative-electrode side detection unit 522, and the command signals for the positive-electrode side power supply unit 531 and the negative-electrode side power supply unit 532 are input as the alternating currents I1 and I2 to the computation unit 550. Then, the computation unit 550 computes the amplitudes of the alternating currents I1 and 12 and the amplitudes of the alternating-current potential differences V1 and V2.

The computation unit 550 computes the internal impedance of the fuel cell stack 1 on the basis of the alternating-current potential differences V1 and V2 and the alternating currents I1 and 12. For example, the computation unit 550 computes the real axis component of the alternating-current potential difference V1 as the amplitude of the alternating-current potential difference V1 on the basis of the detection signal from the positive-electrode side detection unit 521 and computes the real axis component of the alternating-current potential difference V2 as the amplitude of the alternating-current potential difference V2 on the basis of the detection signal from the negative-electrode side detection unit 522.

Then, the computation unit 550 calculates the internal resistance R1 by dividing the real axis component of the alternating-current potential difference V1 by the real axis component of the alternating current I1 and calculates the internal resistance R2 by dividing the real axis component of the alternating-current potential difference V2 by the real axis component of the alternating current 12. It should be noted that the computation unit 550 may compute imaginary axis components of the alternating-current potential differences V1 and V2 and calculate an electrostatic capacitance of the fuel cell stack 1 in addition to the internal resistance of the fuel cell stack 1.

Further, the computation unit 550 may compute an average or effective value of the alternating-current potential difference V1 instead of the real axis components of the alternating-current potential differences V1 and V2 and calculate the internal resistances R1 and R2.

For example, the computation unit 550 computes effective values of the alternating current potential differences V1 and V2 on the basis of the detection signals from the positive-electrode side detection unit 521 and the negative-electrode side detection unit 522 and computes effective values of the alternating currents I1 and I2 on the basis of the command signals from the alternating current adjustment unit 540. Then, the computation unit 550 calculates the internal resistance R1 by dividing the effective value of the alternating-current potential difference V1 by that of the alternating current I1 and calculates the internal resistance R2 by dividing the effective value of the alternating-current potential difference V2 by that of the alternating current 12.

The computation unit 550 includes an AD (Analog-Digital) converter 551 and a microcomputer chip 552.

The AD converter 551 converts the command signals (I1, I2) of the alternating currents and the detection signals (V1, V2) of the alternating-current potential differences, which are analog signals, into digital numeric signals and transfers them to the microcomputer chip 552.

The microcomputer chip 552 stores a program for calculating an internal resistance Rn and the internal resistance R of the entire fuel cell stack 1 in advance. The microcomputer chip 552 successively computes the internal resistance R at prescribed minute time intervals or outputs a computation result according to a request of the control unit 6. It should be noted that the internal resistance Rn and the internal resistance R of the entire fuel cell stack 1 are computed by the following equations.

[Equations 1]

$$\text{Computation equation for resistance} \quad Rn = \frac{Vn}{In}(n = 1,2,....n) \qquad ...(1\text{-}1)$$

$$\text{Overall resistance value} \qquad R = \sum Rn \qquad ...(1\text{-}2)$$

The computation unit 550 is realized, for example, by an analog computation circuit using an analog computation IC. By using the analog computation circuit, a temporally continuous change of the resistance value can be output to the control unit 6.

The control unit 6 receives the internal resistance R output from the computation unit 550 as a measurement result of the impedance measuring device 5. The control unit 6 controls an operating state of the fuel cell stack 1 according to the measurement result of the internal resistance R.

For example, the control unit 6 judges that the electrolyte membranes 111 of the fuel cell stack 1 are dry and reduces a flow rate of the cathode gas supplied to the fuel cell stack 1 if the internal resistance R is high. In this way, the amount of moisture carried out from the fuel cell stack 1 can be reduced.

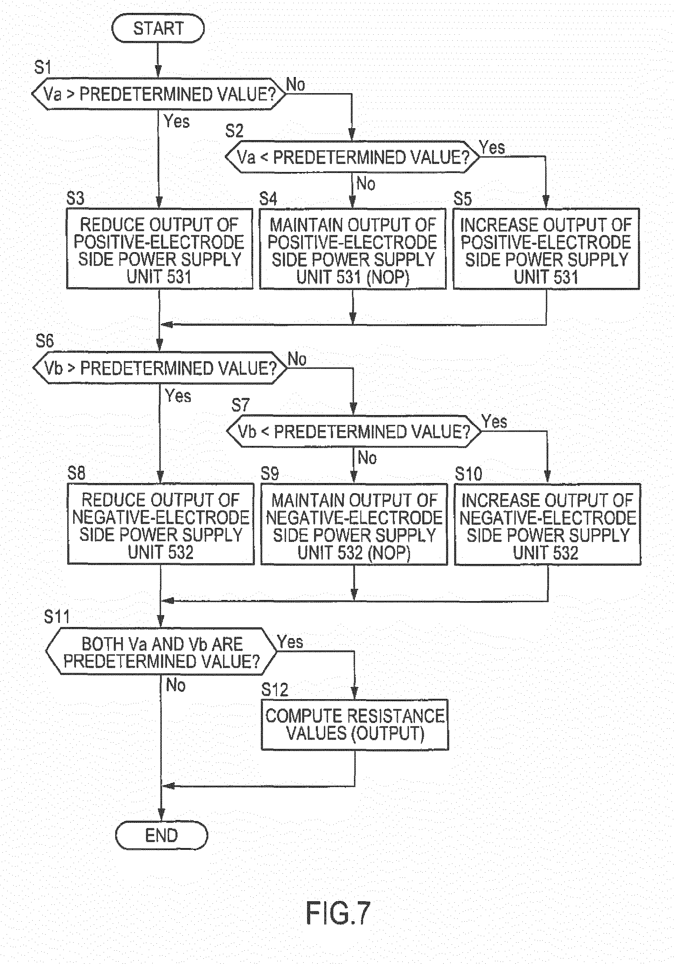

FIG. 7 is a flow chart showing an example of a control method when the equipotential control executed by the alternating current adjustment unit 540 is realized by a controller.

In Step S1, the controller determines whether or not the positive electrode alternating-current potential Va is larger than a prescribed value. The controller proceeds to Step S2 if a determination result is negative while proceeding to Step S3 if the determination result is affirmative.

In Step S2, the controller determines whether or not the positive electrode alternating-current potential Va is smaller than the prescribed value. The controller proceeds to Step S4 if a determination result is negative while proceeding to Step S5 if the determination result is affirmative.

In Step S3, the controller reduces the output of the positive-electrode side power supply unit 531. Specifically, the amplitude of the alternating current I1 is reduced. In this way, the positive electrode alternating-current potential Va decreases.

In Step S4, the controller maintains the output of the positive-electrode side power supply unit 531. In this way, the positive electrode alternating-current potential Va is maintained.

In Step S5, the controller increases the output of the positive-electrode side power supply unit 531. In this way, the positive electrode alternating-current potential Va increases.

In Step S6, the controller determines whether or not the negative electrode alternating-current potential Vb is larger than the prescribed value. The controller proceeds to Step S7 if a determination result is negative while proceeding to Step S8 if the determination result is affirmative.

In Step S7, the controller determines whether or not the negative electrode alternating-current potential Vb is smaller than the prescribed value. The controller proceeds to Step S9 if a determination result is negative while proceeding to Step S10 if the determination result is affirmative.

In Step S8, the controller reduces the output of the negative-electrode side power supply unit 532. In this way, the negative electrode alternating-current potential Vb decreases.

In Step S9, the controller maintains the output of the negative-electrode side power supply unit 532. In this way, the negative electrode alternating-current potential Vb is maintained.

In Step S10, the controller increases the output of the negative-electrode side power supply unit 532. In this way, the negative electrode alternating-current potential Vb increases.

In Step S11, the controller determines whether or not the alternating-current potentials Va and Vb are the prescribed value. The controller proceeds to Step S12 if a determination result is affirmative while exiting from the process if the determination result is negative.

In Step S12, the controller computes the internal resistances in accordance with the aforementioned equations (1-1) and (1-2).

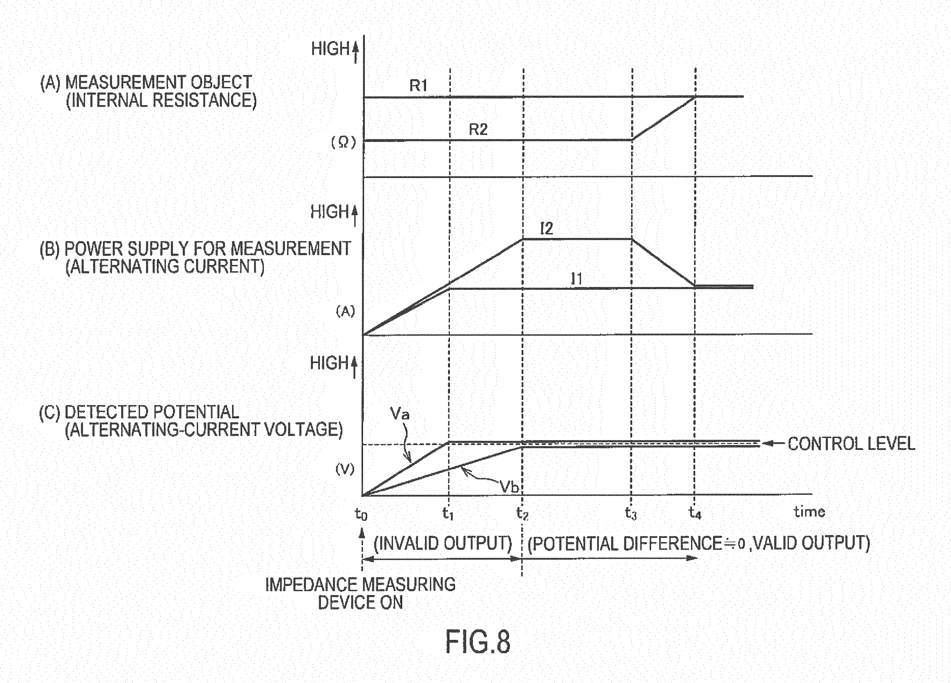

FIGS. 8 are time charts when the equipotential control executed by the alternating-current adjustment unit 540 is executed by the controller. It should be noted that step numbers are also written to make correspondence with the flow chart easily understandable.

In an initial stage in FIGS. 8, the internal resistance value R1 on the positive electrode side is higher than the internal resistance value R2 on the negative electrode side (FIG. 8(A)). The controller starts the control in such a state.

At time t0, neither the positive electrode alternating-current potential Va nor the negative electrode alternating-current potential Vb has reached a control level (FIG. 8C)). In this state, the controller repeats Steps S1→S2→S5→S6→S7→S10→S11. This causes the alternating current I1 on the positive electrode side and the alternating current 12 on the negative electrode side to increase (FIG. 8(B)).

When the positive electrode alternating-current potential Va reaches the control level at time t1 (FIG. 8(C)), the controller repeats Steps S1→S2→S4→S6→S7→S10→S11. This causes the alternating current I1 on the positive electrode side to be maintained and the alternating current 12 on the negative electrode side to increase (FIG. 8(B)).

When the negative electrode alternating-current potential Vb also reaches the control level to have the same level as the positive electrode alternating-current potential Va at time t2 (FIG. 8(C)), the controller repeats Steps S1→S2→S4→S6→S7→S9→S11→S12. This causes the alternating current I1 on the positive electrode side and the alternating current 12 on the negative electrode side to be maintained. Then, the internal resistance value R1 on the positive electrode side and the internal resistance value R2 on the negative electrode side are computed in accordance with equation (1-1). Then, the overall internal resistance value R is computed by adding the internal resistance value R1 on the positive electrode side and the internal resistance value R2 on the negative electrode side.

The internal resistance value R2 on the negative electrode side increases due to a change in a wet state of the fuel cell stack 1 or the like at and after time t3 (FIG. 8(A)). In this case, the controller repeats Steps S1→S2→S4→S6→S8→S11→S12. Since the alternating current I2 on the negative electrode side is reduced in accordance with an increase of the internal resistance value R2 on the negative electrode side by processing in this way, the negative electrode alternating-current potential Vb is maintained at the same level as the positive electrode alternating-current potential Va. Thus, the internal resistance R is computed also in this state.

At and after t4, the internal resistance value R2 on the negative electrode side coincides with the internal resistance value R1 on the positive electrode side (FIG. 8(A)). In this case, the controller repeats Steps S1→S2→S4→S6→S7→S9→S11→S12. The alternating-current potential Va on the positive electrode side and the alternating-current potential Vb on the negative electrode side are maintained at the same level (FIG. 8(C)) by processing in this way, and the internal resistance R is computed.

Next, functions and effects of the equipotential control of the impedance measuring device 5 are described.

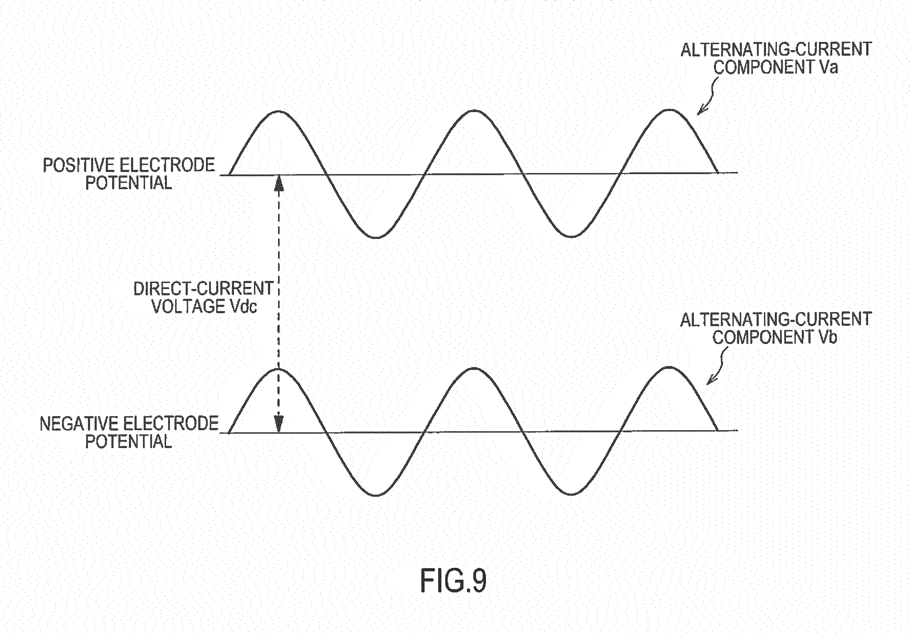

FIG. 9 is a chart illustrating states of the positive electrode potential generated on the positive electrode terminal 211 of the fuel cell stack 1 and the negative electrode potential generated at the negative electrode terminal 212.

During the output of the fuel cell stack 1, a direct-current voltage Vdc to be output to the load 3 is generated between the positive electrode terminal 211 and the negative electrode terminal 212. Before the impedance measuring device 5 is started (ON), the positive electrode potential and the negative electrode potential are constant and the direct current voltage Vdc is supplied to the load 3. Thereafter, when the impedance measuring device 5 is started and the alternating currents I1 and I2 are output from the positive-electrode side power supply unit 531 and the negative-electrode side power supply unit 532, the alternating-current potential Va is superimposed on the positive electrode potential and the alternating-current potential Vb is superimposed on the negative electrode potential.

Then, in accordance with the command signals by the alternating current adjustment unit 540, the positive-electrode side power supply unit 531 and the negative-electrode side power supply unit 532 output the alternating currents I1 and I2 having the amplitudes adjusted such that the alternating-current potential differences V1 and V2 coincide with each other.

The alternating current 11 output from the positive-electrode side power supply unit 531 is supplied to the positive electrode terminal 211 of the fuel cell stack 1 via the positive-electrode side direct current shut-off unit 511 and output to the positive-electrode side detection unit 521 via the intermediate-point terminal 213 and the intermediate point direct current shut-off unit 513. At this time, the alternating-current potential difference V1 (= Va-Vc) is generated between the positive electrode terminal 211 and the intermediate-point terminal 213 due to a voltage drop at the internal resistance R1 by the supply of the alternating current I1 to the internal resistance R1. This alternating-current potential difference V1 is detected by the positive-electrode side detection unit 521.

On the other hand, the alternating current I2 output from the negative-electrode side power supply unit 532 is supplied to the negative electrode terminal 212 of the fuel cell stack 1 via the negative-electrode side direct current shut-off unit 512 and output to the negative-electrode side detection unit 522 via the intermediate-point terminal 213 and the intermediate point direct current shut-off unit 513. At this time, the alternating-current potential difference V2 (= Vb-Vc) is generated between the negative electrode terminal 212 and the intermediate-point terminal 213 due to a voltage drop at the internal resistance R2 by the supply of the alternating current 12 to the internal resistance R2. This alternating-current potential difference V2 is detected by the negative-electrode side detection unit 522.

The alternating current adjustment unit 540 adjusts the positive-electrode side power supply unit 531 and the negative-electrode side power supply unit 532 such that a difference (V1-V2) between the alternating-current potential difference V1 on the positive electrode side of the fuel cell stack 1 and the alternating-current potential difference V2 on the negative electrode side, i.e. a difference (Va-Vb) between the alternating-current potentials Va and Vb is constantly small. Since the amplitude of the alternating-current component Va of the positive electrode potential and that of the alternating-current component Vb of the negative electrode potential are adjusted to be equal in this way, the direct-current voltage Vdc is constant without varying.

The computation unit 550 applies Ohm's law using the alternating-current potential differences V1 and V2 output from the positive-electrode side detection unit 521 and the negative-electrode side detection unit 522 and the alternating currents I1 and I2 output from the positive-electrode side power supply unit 531 and the negative-electrode side power supply unit 532. In this way, the internal resistance R1 on the positive electrode side and the internal resistance R2 of the negative electrode side of the fuel cell stack 1 are calculated.

Here, since the alternating-current potentials of the positive electrode terminal 211 and the negative electrode terminal 212 have the same value, the leakage of the alternating current I1 or I2 to the load 3 can be suppressed even if the load 3 such as a travel motor is connected to the positive electrode terminal 211 and the negative electrode terminal 212. Thus, the internal resistances R1 and R2 of the fuel cell stack 1 can be accurately measured by the alternating current values output from the positive-electrode side power supply unit 531 and the negative-electrode side power supply unit 532.

Further, without depending on the state of the load 3, the internal resistance R of the entire fuel cell stack 1 can be accurately measured on the basis of the measurement values of the internal resistances R1 and R2 of the fuel cell stack 1 in operation. Further, since the positive-electrode side power supply unit 531 and the negative-electrode side power supply unit 532 are used, the internal resistance R can be measured even while the fuel cell stack 1 is stopped.

However, the positive-electrode side power supply unit 531 and the negative-electrode side power supply unit 532, the positive-electrode side detection unit 521 and the negative-electrode side detection unit 522, the alternating current adjustment unit 540 and the like provided in the impedance measuring device 5 are configured by electronic components such as operational amplifiers, i.e. analog circuits. Since such electronic components are subject to manufacturing variations, deterioration with time, i.e. performance deterioration with the passage of time, temperature drifts, i.e. variations of output values associated with a temperature increase and the like, accuracy in measuring the internal impedance is reduced due to these.

As a measure against this, it is also considered to use high-precision electronic components having very small manufacturing variations, deterioration with time and temperature drifts. However, since cost increases in the case of using high-precision electronic components, it becomes an obstacle to a reduction in the manufacturing cost of the impedance measuring device 5.

Accordingly, in the present embodiment, the impedance measuring device 5 diagnoses a reduction of measurement accuracy due to manufacturing variations, deterioration with time and the like of the electronic components of its own.

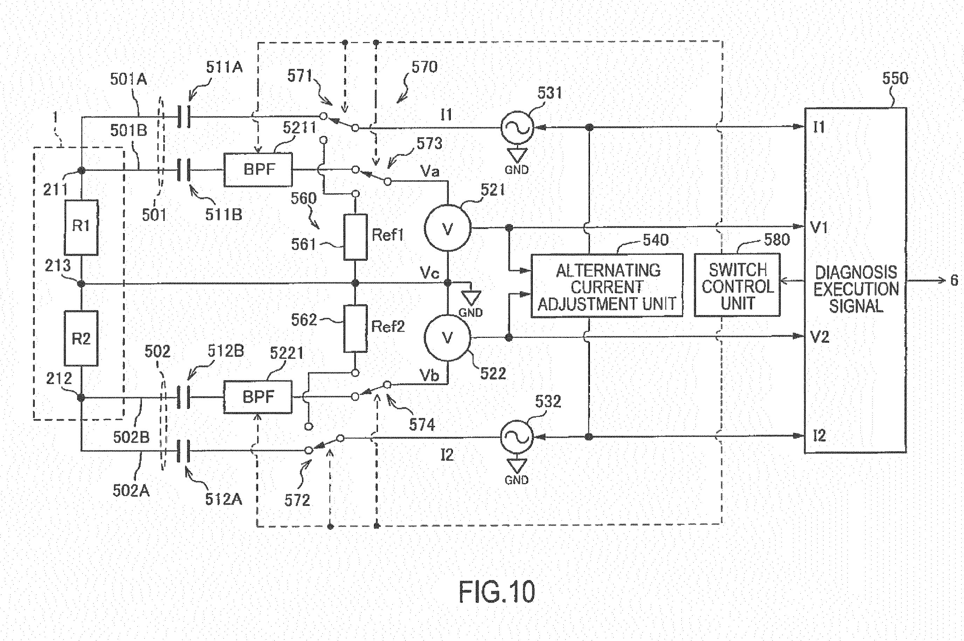

FIG. 10 is a diagram showing a detailed configuration of the impedance measuring device 5 in the present embodiment. Here, the constituent parts identical to those shown in FIG. 2 are denoted by the same reference signs and not described in detail.

In FIG. 10, a signal line 501 is divided into an input line 501A along which the alternating current I1 is input from the positive-electrode side power supply unit 531 to the positive electrode terminal 211 of the fuel cell stack 1 and an output line 501B along which the alternating-current potential Va is output from the positive electrode terminal 211 to the positive-electrode side detection unit 521.

Similarly, a signal line 502 is divided into an input line 502A along which the alternating current I2 is input from the negative-electrode side power supply unit 532 to the negative electrode terminal 212 of the fuel cell stack 1 and an output line 502B along which the alternating-current potential Vb is output from the negative electrode terminal 212 to the negative-electrode side detection unit 522. By dividing each of the signal lines 501 and 502 into two lines as just described, only the alternating-current potential signals output from the positive electrode terminal 211 and the negative electrode terminal 212 can be detected by the positive-electrode side detection unit 521 and the negative-electrode side detection unit 522. Thus, the measurement accuracy of the impedance measuring device 5 can be improved.

A capacitor 511A is connected as the direct current shut-off unit 511 shown in FIG. 2 to the input line 501A and a capacitor 511B is connected as the direct current shut-off unit 511 also to the output line 501B. Similarly, a capacitor 512A is connected as the direct current shut-off unit 512 to the input line 502A and a capacitor 512B is connected as the direct current shut-off unit 512 also to the output line 502B.

In addition to the basic configuration shown in FIG. 2, the impedance measuring device 5 includes a diagnosis element unit 560, a switching unit 570 and a switch control unit 580. Further, the impedance measuring device 5 includes band-pass filters 5211 and 5221.

The diagnosis element unit 560 is provided to diagnose a reduction in the measurement accuracy of the impedance measuring device 5 and includes diagnosis elements having impedances of predetermined values.

For example, an impedance element such as a resistance element, a capacitor element or an inductor element is used as the diagnosis element in accordance with the resistance, electrostatic capacitance and the like to be measured by the impedance measuring device 5. For example, a coil is used as the inductor element. Further, an impedance element in which a resistance element and a capacitor element are connected in parallel may be used as the diagnosis element. In this way, measurement errors of the resistance, electrostatic capacitance and the like of the impedance measuring device 5 can be measured.

In the present embodiment, the diagnosis element unit 560 includes a diagnosis element 561 on the positive electrode side and a diagnosis element 562 on the negative electrode side.

The diagnosis element 561 has a resistance of a predetermined reference value Ref1 and the diagnosis element 562 has a resistance of a predetermined reference value Ref2.

The diagnosis element 561 is arranged at such a position to be connectable in parallel to the positive -electrode side detection unit 521. The diagnosis element 562 is arranged at such a position to be connectable in parallel to the negative-electrode side detection unit 522. The reference values Ref1 and Ref2 are set at values within a range in which the internal resistances R1 and R2 of the fuel cell stack 1 vary.

For example, the reference values Ref1 and Ref2 are set at resistance values in a region where particularly high measurement accuracy is required within the variation range of the internal resistances R1 and R2. In a system in which an internal resistance of a laminated battery is controlled to be a specific value, e.g. an intermediate value of a measurement range, the reference values Ref1 and Ref2 are set at such a specific value.

Alternatively, the reference values Ref1 and Ref2 may be set at a lower limit value of the variation range of the internal resistances R1 and R2 to sufficiently ensure a signal-noise ratio. Since the resistances of the diagnosis elements 561 and 562 are minimum values in the variation range in this case, the amplitudes of the alternating currents I1 and I2 are adjusted to a maximum value of a variable range such that the amplitudes of the alternating-current potential differences V1 and V2 generated in the diagnosis elements 561 and 562 increase to the reference voltage Vs by the equipotential control. Thus, the resistances of the diagnosis elements 561 and 562 are measured with the signal-noise ratio maximized, wherefore the measurement accuracy of the resistances of the diagnosis elements 561 and 562 is increased.

For example, resistors of 50 mΩ (milliohms) are used as the diagnosis elements 561 and 562.

The switching unit 570 switches a connection state of a signal path in which alternating-current signals in the impedance measuring device 5 pass to a battery connection state for measuring the internal resistances R1 and R2 of the fuel cell stack 1 or an element connection state for measuring the resistances of the diagnosis elements 561 and 562.

In the battery connection state, the switching unit 570 connects the positive-electrode side power supply unit 531 to the positive electrode terminal 211 and connects the positive-electrode side detection unit 521 in parallel to the internal resistance R1 on the positive electrode side between the positive electrode terminal 211 and the intermediate-point terminal 213 in the fuel cell stack 1. Then, the switching unit 570 connects the negative-electrode side power supply unit 532 to the negative electrode terminal 212 and connects the negative-electrode side detection unit 522 in parallel to the internal resistance R2 on the negative electrode side between the negative electrode terminal 212 and the intermediate-point terminal 213 in the fuel cell stack 1.

On the other hand, in the element connection state, the switching unit 570 cuts off the positive-electrode side power supply unit 531 from the positive electrode terminal 211 of the fuel cell stack 1 and connects it to the diagnosis element 561, and connects the diagnosis element 561 in parallel to the positive-electrode side detection unit 521. Then, the switching unit 570 cuts off the negative-electrode side power supply unit 532 from the negative electrode terminal 212 and connects it to the diagnosis element 562, and connects the diagnosis element 562 in parallel to the negative-electrode side detection unit 522.

The switching unit 570 includes current path switchers 571 and 572 and detection object switchers 573 and 574. The current path switchers 571 and 572 and the detection object switchers 573 and 574 are realized, for example, by analog switches, relays or the like.

The current path switcher 571 is connected between the positive-electrode side power supply unit 531 and the capacitor 511A. Then, the current path switcher 571 switches a supply destination of the alternating current I1 output from the positive-electrode side power supply unit 531 to the positive electrode terminal 211 of the fuel cell stack 1 or the diagnosis element 561.

In the current path switcher 571, an input terminal is connected to the positive-electrode side power supply unit 531, a first output terminal is connected to the capacitor 511A and a second output terminal is connected to the diagnosis element 561.

The current path switcher 572 is connected between the negative-electrode side power supply unit 532 and the capacitor 512A. Then, the current path switcher 572 switches a supply destination of the alternating current I2 output from the negative-electrode side power supply unit 532 to the negative electrode terminal 212 of the fuel cell stack 1 or the diagnosis element 562.

In the current path switcher 572, an input terminal is connected to the negative-electrode side power supply unit 532, a first output terminal is connected to the capacitor 512A and a second output terminal is connected to the diagnosis element 562.

The detection object switcher 573 is connected between the band-pass filter 5211 and the positive-electrode side detection unit 521. Then, the detection object switcher 573 switches a detection object to be connected in parallel to the positive-electrode side detection unit 521 to a positive-electrode side part from the positive electrode terminal 211 to the intermediate-point terminal 213 of the fuel cell stack 1 or the diagnosis element 561.

In the detection object switcher 573, a first input terminal is connected to the band-pass filter 5211, a second input terminal is connected to the diagnosis element 561 and an output terminal is connected to the positive-electrode side detection unit 521.

The detection object switcher 574 is connected between the band-pass filter 5221 and the negative-electrode side detection unit 522. Then, the detection object switcher 574 switches a detection object to be connected in parallel to the negative-electrode side detection unit 522 to a negative-electrode side part from the negative electrode terminal 212 to the intermediate-point terminal 213 of the fuel cell stack 1 or the diagnosis element 562.

In the detection object switcher 574, a first input terminal is connected to the band-pass filter 5221, a second input terminal is connected to the diagnosis element 562 and an output terminal is connected to the negative-electrode side detection unit 522.

In FIG. 10, the switching unit 570 is set in the battery connection state for connecting the positive-electrode side power supply unit 531 and the positive-electrode side detection unit 521 to the positive electrode terminal 211 of the fuel cell stack 1 and connecting the negative-electrode side power supply unit 531 and the negative-electrode side detection unit 522 to the negative electrode terminal 212.

Specifically, in the current path switcher 571, the input terminal connected to the positive-electrode side power supply unit 531 is connected to the first output terminal connected to the capacitor 511A. This causes the alternating current I1 output from the positive-electrode side power supply unit 531 to be supplied to the positive electrode terminal 211 of the fuel cell stack 1.

Similarly, in the current path switcher 572, the input terminal connected to the negative-electrode side power supply unit 532 is connected to the first output terminal connected to the capacitor 511B. This causes the alternating current I2 output from the negative-electrode side power supply unit 532 to be supplied to the negative electrode terminal 212 of the fuel cell stack 1.

In the detection object switcher 573, the output terminal connected to the positive-electrode side detection unit 521 is connected to the first input terminal connected to the band-pass filter 5211. Since this causes the internal resistance R1 between the positive electrode terminal 211 and the intermediate-point terminal 213 of the fuel cell stack 1 to be connected in parallel to the positive-electrode side detection unit 521, the alternating-current potential Va is output from the positive electrode terminal 211 to the positive-electrode side detection unit 521.

In the detection object switcher 574, the output terminal connected to the negative-electrode side detection unit 522 is connected to the first input terminal connected to the band-pass filter 5221. Since this causes the internal resistance R2 between the negative electrode terminal 212 and the intermediate-point terminal 213 of the fuel cell stack 1 to be connected in parallel to the negative-electrode side detection unit 522, the alternating-current potential Vb is output from the negative electrode terminal 212 to the negative-electrode side detection unit 522.

Both the current path switchers 571 and 572 and the detection object switchers 573 and 574 described above are controlled by the switch control unit 580.

The switch control unit 580 switches the connection state to the battery connection state for connecting the positive-electrode side power supply unit 531 and the positive-electrode side detection unit 521 to the positive electrode terminal 211 of the fuel cell stack 1 or the element connection state for connecting the positive-electrode side power supply unit 531 and the positive-electrode side detection unit 521 to the diagnosis element 561.

Further, the switch control unit 580 switches the connection state to the battery connection state for connecting the negative-electrode side power supply unit 532 and the negative-electrode side detection unit 522 to the negative electrode terminal 212 of the fuel cell stack 1 or the element connection state for connecting the negative-electrode side power supply unit 532 and the negative-electrode side detection unit 522 to the diagnosis element 562.

The switch control unit 580 switches the connection state of the switching unit 570 from the battery connection state for measuring the internal resistance of the fuel cell stack 1 to the element connection state for measuring the resistances of the diagnosis elements 561 and 562 when a predetermined diagnosis timing is reached. In this way, a process of diagnosing the measurement state of the impedance measuring device 5 is performed.

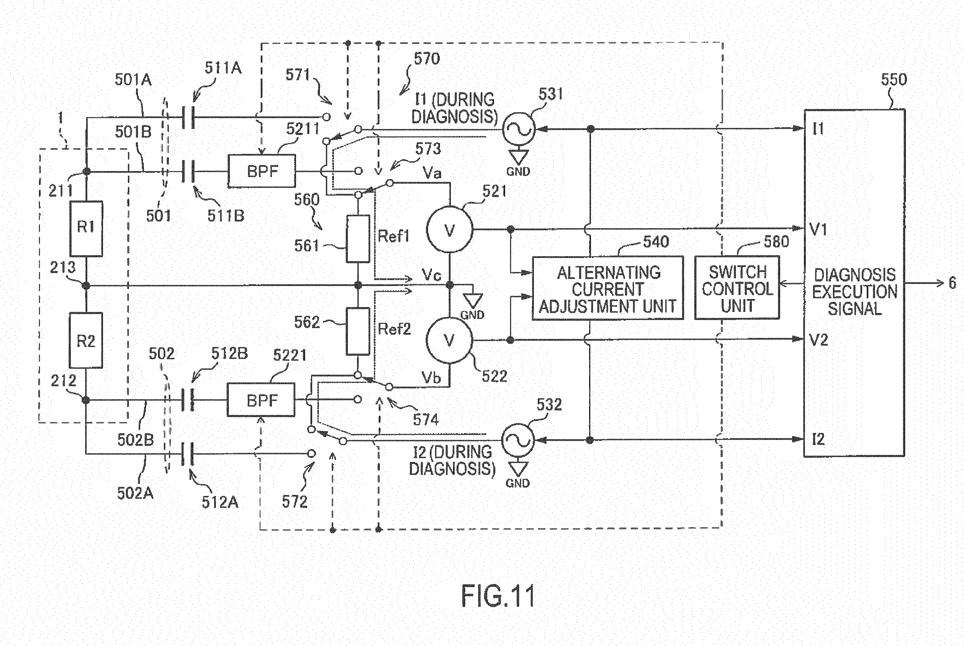

FIG. 11 is a diagram showing the connection state of the switching unit 570 when the measurement state of the impedance measuring device 5 is diagnosed.

In the current path switcher 571, the input terminal connected to the positive-electrode side power supply unit 531 is switched from the first output terminal connected to the capacitor 511A to the second output terminal connected to the diagnosis element 561. This causes the alternating current I1 output from the positive-electrode side power supply unit 531 to be supplied to the diagnosis element 561.

Similarly, in current path switcher 572, the input terminal connected to the negative-electrode side power supply unit 532 is switched from the first output terminal connected to the capacitor 511B to the second output terminal connected to the diagnosis element 562. This causes the alternating current I2 output from the negative-electrode side power supply unit 532 to be supplied to the diagnosis element 562.

In the detection object switcher 573, the output terminal connected to the positive-electrode side detection unit 521 is switched from the first input terminal connected to the band-pass filter 5211 to the second input terminal connected to the diagnosis element 561. Since this causes the diagnosis element 561 to be connected in parallel to the positive-electrode side detection unit 521, the alternating-current potential difference V1 generated by the diagnosis element 561 is detected by the positive-electrode side detection unit 521 and output to the alternating current adjustment unit 540.

In the detection object switcher 574, the output terminal connected to the negative-electrode side detection unit 522 is switched from the first input terminal connected to the band-pass filter 5221 to the second input terminal connected to the negative-electrode side detection unit 522. Since this causes the diagnosis element 562 to be connected in parallel to the negative-electrode side detection unit 522, the alternating-current potential difference V2 generated by the diagnosis element 562 is detected by the negative-electrode side detection unit 522 and output to the alternating current adjustment unit 540.

The alternating current adjustment unit 540 adjusts the amplitudes of the alternating currents I1 and I2 output from the positive-electrode side power supply unit 531 and the negative-electrode side power supply unit 532 such that the alternating-current potential difference V1 generated in the diagnosis element 561 and the alternating-current potential difference V2 generated in the diagnosis element 562 become equal to each other.

The computation unit 550 receives a command signal corresponding to the alternating current I1 and a command signal corresponding to the alternating current 12 from the alternating current adjustment unit 540 and receives the alternating-current potential difference V1 from the positive-electrode side detection unit 521 and the alternating-current potential difference V2 from the negative-electrode side detection unit 522. The computation unit 550 computes the resistance R1 of the diagnosis element 561 on the basis of the alternating current I1 and the alternating-current potential difference V1 as in equation (1-1) and holds that resistance R1 as a measurement value. Further, the computation unit 550 computes the resistance R2 of the diagnosis element 562 on the basis of the alternating current I2 and the alternating-current potential difference V2 as in equation (1-1) and holds that resistance R2 as a measurement value.

The computation unit 550 calculates a difference between the measurement value of the resistance of the diagnosis element 561 and the reference value Ref1 as a measurement error of the diagnosis element 561 and calculates a difference between the measurement value of the resistance of the diagnosis element 562 and the reference value Ref2 as a measurement error of the diagnosis element 562.

The computation unit 550 diagnoses on the basis of the measurement errors of the diagnosis elements 561 and 562 whether the measurement state of the impedance measuring device 5 is good or bad, and transmits that diagnosis result to the control unit 6.

For example, the computation unit 550 judges whether or not the measurement error of the diagnosis element 561 and the measurement error of the diagnosis element 562 have exceeded a predetermined allowable error range. Then, the computation unit 550 determines that the measurement state of the impedance measuring device 5 is good if the measurement errors of the diagnosis elements 561 and 562 are both within the allowable error range. Specifically, it is determined that impedance measurement accuracy has not been reduced due to the manufacturing variations, deterioration with time and the like of the electronic components provided in the impedance measuring device 5.

If the measurement state of the impedance measuring device 5 is determined to be good, the computation unit 550 supplies a diagnosis end signal indicating the end of the diagnosis to the switch control unit 580. The switch control unit 580 switches the connection state of the switching unit 570 from the element connection state for measuring the resistance of the diagnosis elements 561 and 562 to the battery connection state shown in FIG. 10 when receiving the diagnosis end signal.

Then, the computation unit 550 computes the internal resistance R of the fuel cell stack 1 in a state where the alternating-current potential differences V1 and V2 are controlled to be equal to each other by the equipotential circuit, and transmits that internal resistance R as a measurement result to the control unit 6.

On the other hand, if the measurement error of the diagnosis element 561 or 562 has exceeded the allowable error range, the computation unit 550 determines that the measurement state of the impedance measuring device 5 is bad. Specifically, it is determined that impedance measurement accuracy has been reduced due to the manufacturing variations, deterioration with time and the like of the electronic components provided in the impedance measuring device 5.

If the measurement state of the impedance measuring device 5 is determined to be bad, the computation unit 550, for example, stops the supply of the diagnosis end signal to the switch control unit 580 and prohibits the switch of the connection state of the switching unit 570 to the battery connection state.

Alternatively, the computation unit 550 may supply the diagnosis end signal to the switch control unit 580, switch the switching unit 570 to the battery connection state and correct the measurement value of the internal resistance R of the fuel cell stack 1 on the basis of the measurement errors of the diagnosis element 561 and 562 calculated during diagnosis.

In this case, if the measurement values of the diagnosis elements 561 and 562 are smaller than the reference value, the computation unit 550 calculates the internal resistance R, for example, by adding the measurement error of the diagnosis element 561 to the measurement value of the internal resistance R1 and adding the measurement error of the diagnosis element 562 to the measurement value of the internal resistance R2. Alternatively, the computation unit 550 may correct the measurement value by adding an average value of the measurement error of the diagnosis element 561 and that of the diagnosis element 562 to the measurement value of the internal resistance R. The computation unit 550 transmits that measurement value after the correction to the control unit 6.

As another example, the computation unit 550 may switch the switching unit 570 to the battery connection state, add the measurement errors of the diagnosis elements 561 and 562 to the measurement result of the internal resistance R and transmit the sum to the control unit 6 when the measurement state is determined to be bad. Since a plurality of control blocks for controlling a cathode gas supply flow rate, an anode gas supply flow rate and a cooling water temperature of the fuel cell stack 1 are present in the control unit 6, it is possible to change how to handle the measurement result according to the measurement errors added to the measurement result if the required measurement accuracy of the internal resistance R differs for each control block.

It should be noted that although an example in which resistors having resistances of fixed values are used as the diagnosis elements 561 and 562 has been described in the present embodiment, capacitor elements or inductance elements may be used instead of the resistors.

For example, not only resistance components, but also electrostatic capacitance components are included in the fuel cell stack 1. Thus, in the case of measuring the electrostatic capacitance of the fuel cell stack 1, capacitor elements having a prescribed value are provided in the impedance measuring device 5. During diagnosis, the impedance measuring device 5 switches the switching unit 570 to the element connection state, obtains the measurement errors of the electrostatic capacitances of the capacitor elements and diagnoses on the basis of those measurement errors whether or not the measurement state of the electrostatic capacitance of the fuel cell stack 1 is good.

Further, impedance elements in which resistance elements and capacitor elements are connected in parallel may be used as the diagnosis elements 561 and 562. In this case, the computation unit 550 computes the real axis components and the imaginary axis components of the alternating-current potential differences V1 and V2, obtains the measurement errors of the resistance elements on the basis of these real axis components and obtains the measurement errors of the capacitor elements on the basis of the imaginary axis components.

This enables the measurement accuracy of both the internal resistance and the electrostatic capacitance of the impedance measuring device 5 to be diagnosed without providing switchers for switching the resistance elements and the capacitor elements. Specifically, reliability for the measurement accuracy of the impedance measuring device 5 can be ensured without complicating a circuit configuration of the impedance measuring device 5.

Further, since a multitude of the power generation cells 10 are laminated in the fuel cell stack 1, a voltage supplied from the fuel cell stack 1 to the load 3 is a direct-current voltage as high as several hundreds of volts. Thus, the capacitors 511A, 511B, 512A and 512B are provided in the impedance measuring device 5 to shut off the direct-current voltage supplied from the fuel cell stack 1 to the impedance measuring device 5.

Specifically, the capacitor 511A is connected as the direct current shut-off unit 511 to the input line 501A between the positive electrode terminal 211 of the fuel cell stack 1 and the positive-electrode side power supply unit 531 and the capacitor 511B is connected to the output line 501B between the positive electrode terminal 211 and the positive-electrode side detection unit 521. Further, the capacitor 512A is connected as the direct current shut-off unit 512 to the input line 502A between the negative electrode terminal 212 of the fuel cell stack 1 and the negative-electrode side power supply unit 532 and the capacitor 512B is connected to the output line 502B between the negative electrode terminal 212 and the negative-electrode side detection unit 522.

In a measurement path on the positive electrode side, the current path switcher 571 is connected between the capacitor 511A and the positive-electrode side power supply unit 531 and switches a connection destination, to which the positive-electrode side power supply unit 531 is connected in the battery connection state, from the capacitor 511A to one end of the diagnosis element 561. Further, the detection object switcher 573 is connected between the capacitor 511B and the first input terminal of the positive-electrode side detection unit 521 and switches a connection destination, to which the first input terminal of the positive-electrode side detection unit 521 is connected in the battery connection state, from the capacitor 511B to one end of the diagnosis element 561.

In a measurement path on the negative electrode side, the current path switcher 572 is connected between the capacitor 512A and the negative-electrode side power supply unit 532 and switches a connection destination, to which the negative-electrode side power supply unit 532 is connected in the battery connection state, from the capacitor 512A to one end of the diagnosis element 562. Further, the detection object switcher 574 is connected between the capacitor 512B and the first input terminal of the negative-electrode side detection unit 522 and switches a connection destination, to which the first input terminal of the negative-electrode side detection unit 522 is connected in the battery connection state, from the capacitor 512B to one end of the diagnosis element 562.

Further, the intermediate-point terminal 213 provided on the power generation cell 10 located in the middle between the positive electrode terminal 211 and the positive electrode terminal 212 of the fuel cell stack 1 is connected to the other end of the diagnosis element 561, the other end of the diagnosis element 562, the second input terminal of the positive-electrode side detection unit 521 and the second input terminal of t the negative-electrode side detection unit 522. Along with this, the intermediate-point terminal 213 is grounded.

As just described, the current path switchers 571 and 572 are respectively arranged closer to the power supply units 531 and 532 than the capacitors 511A and 511B, and the detection object switchers 573 and 574 are arranged closer to the detection units 521 and 522 than the capacitors 512A and 512B.

Thus, the current path switchers 571 and 572 and the detection object switchers 573 and 574 are shut off from the direct-current voltage as high as several hundreds of volts from the fuel cell stack 1 by the capacitors 511A, 511B, 512A and 512B, wherefore it is not necessary to prepare switchers with high pressure resistance. Thus, inexpensive switchers can be used and manufacturing cost can be reduced.

On the other hand, since the capacitors 511A, 511B, 512A and 512B are not included in the circuit configuration during diagnosis, influences such as manufacturing variations, deterioration and the like of these are not reflected on the diagnosis. However, the frequencies of the alternating currents I1 and I2, i.e. the reference frequency fb of the alternating-current signal source 546, may be set at a value in a range where the influences of the impedances of the capacitors 511A, 511B, 512A and 512B can be ignored when the internal resistance R of the fuel cell stack 1 is measured. For example, the reference frequency fb is set at a value of 1 kHz (kilohertz) or higher.

In this way, a circuit characteristic when the resistances of the diagnosis elements 561 and 562 are measured approaches a circuit characteristic when the internal resistances R1 and R2 of the fuel cell stack 1 are measured. Thus, accuracy in measuring resistance errors of the diagnosis elements 561 and 562, i.e. diagnosis accuracy of the impedance measuring device 5 can be improved.

Further, since the amplitudes of the alternating currents I1 and I2 are so controlled that the amplitudes of the alternating-current potential differences V1 and V2 have the same reference value Vs in the alternating current adjustment unit 540, it is desirable to provide the intermediate-point terminal 213 in the middle of the internal resistance R of the fuel cell stack 1. Since the fuel cell stack 1 is a laminated battery, it is sufficient that the intermediate-point terminal 213 is provided on the power generation cell 10 located in the middle out of the power generation cells laminated from the positive electrode terminal 211 to the negative electrode terminal 212. Thus, the intermediate-point terminal 213 can be accurately and easily provided in the middle of the internal resistance R.

Furthermore, since the fuel cell stack 1 is a laminated battery and the positive electrode side and the negative electrode side are symmetrical, variations between systems can be reduced by configuring two systems of the measurement path on the positive electrode side and the measurement path on the negative electrode side identically to each other. Further, by dividing each of the signal lines 501 to 502 into two lines, noise mixed from the positive-electrode side power supply unit 531 into the positive-electrode side detection unit 521 and from the negative-electrode side power supply unit 532 to the negative-electrode side detection unit 522 can be suppressed.

Further, although an example in which the band-pass filters 5211 and 5221 are arranged between the capacitors 511B and 512B and the detection object switchers 573 and 574 has been described in the present embodiment, the embodiment of the present invention is not limited to this.

For example, the band-pass filters 5211 and 5221 may be connected between the detection object switchers 573, 574 and the positive-electrode side detection unit 521 and the negative-electrode side detection unit 522. In this case, the band-pass filter 5211 is included in the path from the positive-electrode side power supply unit 531 to the positive-electrode side detection unit 521 in which the alternating current I1 flows during diagnosis, and the band-pass filter 5221 is included also in the path from the negative-electrode side power supply unit 532 to the negative-electrode side detection unit 522 in which the alternating current I2 flows. Specifically, the circuit characteristic when the resistances of the diagnosis elements 561 and 562 are measured approaches the circuit characteristic when the internal resistances R1 and R2 of the fuel cell stack 1 are measured.

In the band-pass filters 5211 and 5221, if amplitude and phase characteristics of an output signal in relation to an input signal change, it also affects impedance measurement accuracy. If output signals of the band-pass filters 5211 and 5221 are reduced due to deterioration with time, the amplitudes of the alternating-current potential differences V1 and V2 are reduced. Thus, even if the internal resistances R1 and R2 are actually constant, resistance values computed by the computation unit 550 are reduced. As just described, the measurement accuracy of the impedance measuring device 5 is reduced due to individual differences and deterioration with time of the band-pass filters 5211 and 5221.

As a measure against this, the detection object switchers 573 and 574 may be arranged in the preceding stages of the band-pass filters 5211 and 5221. By this, deviation widths of output values due to product variations and deterioration with time of the band-pass filters 5211 and 5221 are included in the measurement errors of the diagnosis elements 561 and 562. Thus, measurement errors caused by the electronic components such as the band-pass filters 5211 and 5221 in the impedance measuring device 5 can be more accurately computed.

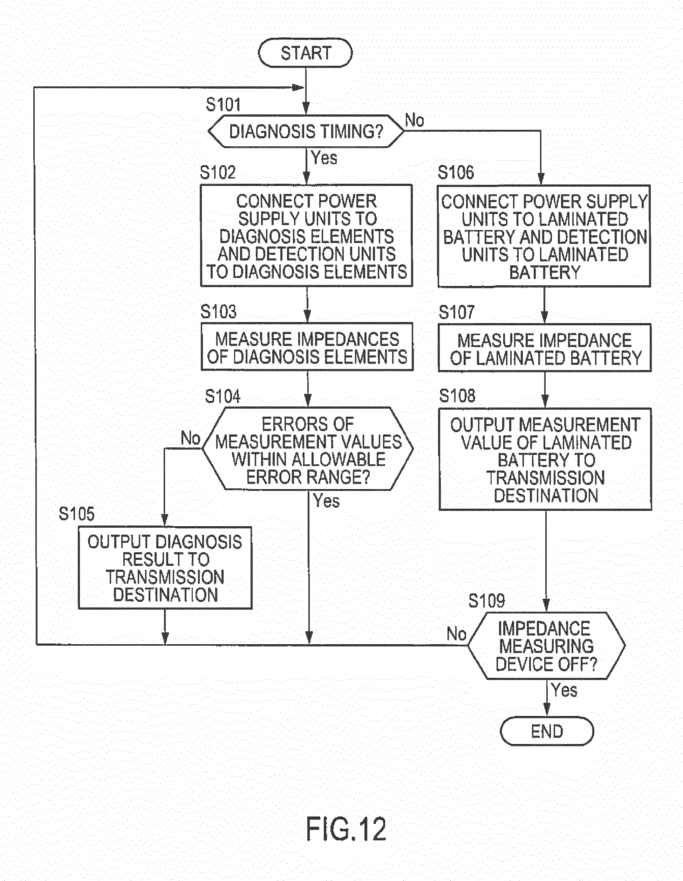

Next, the operation of the impedance measuring device 5 is described with reference to FIG. 12.

FIG. 12 is a flow chart showing an example of an impedance measuring method in the present embodiment.

First, in Step S101, the computation unit 550 judges whether or not the impedance measuring device 5 has reached a diagnosis timing for diagnosing the measurement state of its own. In the case of judging that the diagnosis timing has been reached, the computation unit 550 supplies a diagnosis execution signal to the switch control unit 580. On the other hand, in the case of judging that the diagnosis timing has not been reached, the computation unit 550 stops the supply of the diagnosis execution signal to the switch control unit 580.

In Step S102, the switch control unit 580 controls the current path switchers 571 and 572 to respectively connect the positive-electrode side power supply unit 531 and the negative-electrode side power supply unit 532 to the diagnosis elements 561 and 562 when receiving the diagnosis execution signal from the computation unit 550. Along with this, the switch control unit 580 controls the detection object switchers 573 and 574 to respectively connect the diagnosis elements 561 and 562 in parallel to the positive-electrode side detection unit 521 and the negative-electrode side detection unit 522.

When the impedance measuring device 5 reaches the diagnosis timing in this way, the switch control unit 580 supplies the alternating currents I1 and I2 respectively to the diagnosis elements 561 and 562 and switches the connection state to the element connection state where the alternating-current potential differences V1 and V2 generated in the diagnosis elements 561 and 562 are output. Then, the alternating-current potential differences V1 and V2 are output to the computation unit 550 from the positive-electrode side detection unit 521 and the negative-electrode side detection unit 522 in a state where the amplitudes of the alternating currents I1 and I2 are adjusted by the alternating current adjustment unit 540 such that the alternating-current potential differences V1 and V2 become equal to each other.

In Step S103, the computation unit 550 computes the resistance R1 of the diagnosis element 561 and the resistance R2 of the diagnosis element 562 using the alternating currents 11 and 12 and the alternating-current potential differences V1 and V2 adjusted by the alternating current adjustment unit 540 as in equation (1-1). Specifically, the computation unit 550 measures the impedance of each of the diagnosis elements 561 and 562.

In Step S104, the computation unit 550 judges whether or not both the measurement error between the measurement value of the resistance of the diagnosis element 561 and the reference value Ref1 and the measurement error between the measurement value of the resistance of the diagnosis element 562 and the reference value Ref2 are within the allowable error range.

If the measurement errors of the diagnosis elements 561 and 562 are both within the allowable error range, the computation unit 550 judges that the measurement state of the impedance measuring device 5 is good and returns to Step S101.

On the other hand, if the measurement error of the diagnosis element 561 or 562 is outside the allowable error range, the computation unit 550 judges that the measurement state is bad and outputs a diagnosis result indicating that to the control unit 6 as a transmission destination in Step S105.

It should be noted that the computation unit 550 may transmit the measurement errors of the diagnosis elements 561 and 562, measurement accuracy computed from the measurement errors, a command to stop the measurement in the impedance measuring device 5 or the like as the diagnosis result. After transmitting the diagnosis result, the computation unit 550 returns to Step S101.

As just described, the computation unit 550 diagnoses on the basis of the measurement errors of the diagnosis elements 561 and 562 whether or not the measurement state is bad due to the manufacturing variation, deterioration with time or the like of the impedance measuring device 5.

If it is judged in Step S101 that the impedance measuring device 5 has not reached the diagnosis timing, the computation unit 550 stops the supply of the diagnosis execution signal to the switch control unit 580.

In Step S106, the switch control unit 580 controls the current path switchers 571 and 572 to connect the positive-electrode side power supply unit 531 and the negative-electrode side power supply unit 532 respectively to the positive electrode terminal 211 and the negative electrode terminal 212 of the fuel cell stack 1. Along with this, the switch control unit 580 controls the detection object switchers 573 and 574 to connect the internal resistance R1 between the positive electrode terminal 211 and the intermediate-point terminal 213 to the positive-electrode side detection unit 521 and connect the internal resistance R2 between the negative electrode terminal 212 and the intermediate-point terminal 213 to the negative-electrode side detection unit 522.

In this way, the switch control unit 580 switches the connection state to the battery connection state where the alternating-current potential differences V1 and V2 generated in the internal resistances R1 and R2 are output by supplying the alternating currents I1 and I2 respectively to the internal resistances R1 and R2 of the fuel cell stack 1. Then, the alternating current adjustment unit 540 adjusts the amplitudes of the alternating currents I1 and I2 by controlling the positive-electrode side power supply unit 531 and the negative-electrode side power supply unit 532 such that the alternating-current potential differences V1 and V2 become equal to each other. In this state, the alternating-current potential differences V1 and V2 generated in the internal resistances R1 and R2 of the fuel cell stack 1 are detected by the positive-electrode side detection unit 521 and the negative-electrode side detection unit 522 and output to the computation unit 550. Further, the command signals output to the positive-electrode side power supply unit 531 and the negative-electrode side power supply unit 532 from the alternating current adjustment unit 540 are output as the alternating currents I1 and I2 to the computation unit 550.

In Step S107, the computation unit 550 computes the internal resistances R1 and R2 of the fuel cell stack 1 using the alternating currents I1 and I2 and the alternating-current potential differences V1 and V2 after the adjustment as in equation (1-1). Specifically, the computation unit 550 measures the internal impedance of the fuel cell stack 1.

In Step S108, the computation unit 550 computes the internal resistance R of the entire fuel cell stack 1 by combining the measured internal resistances R1 and R2 as in equation (1-2) and transmits that internal resistance R as a measurement result to the control unit 6. In this case, the computation unit 550 may generate and transmit measurement data obtained by adding the diagnosis result of the measurement errors to the measurement result of the internal resistance R when measuring the internal resistance R after it is judged in Step S104 that the measurement errors of the diagnosis elements 561 and 562 are beyond the allowable error range.

In Step S109, the computation unit 550 repeats a series of processings in Steps S101 to S108 until the impedance measuring device 5 is stopped (OFF) and ends the impedance measuring method when the impedance measuring device 5 is stopped.

According to the first embodiment of the present invention, the impedance measuring device 5 includes the positive-electrode side power supply unit 531 and the negative-electrode side power supply unit 532 for respectively outputting the alternating currents I1 and I2 to the positive electrode terminal 211 and the negative electrode terminal 212 of the fuel cell stack 1.

Further, the impedance measuring device 5 includes the positive-electrode side detection unit 521 for detecting the alternating-current potential difference V1 generated in the internal resistance R1 between the positive electrode terminal 211 and the intermediate-point terminal 213 in the fuel cell stack 1 and further includes the negative-electrode side detection unit 522 for detecting the alternating-current potential difference V2 generated in the internal resistance R2 between the negative electrode terminal 212 and the intermediate-point terminal 213.

Furthermore, the impedance measuring device 5 includes the computation unit 550 for computing the internal resistance R1 of the fuel cell stack 1 on the basis of the alternating-current potential difference V1 detected by the positive-electrode side detection unit 521 and the alternating current 11 output from the positive-electrode side power supply unit 531. The computation unit 550 computes the internal resistance R2 on the basis of the alternating-current potential difference V2 detected by the negative-electrode side detection unit 522 and the alternating current 12 output from the negative-electrode side power supply unit 532.

In addition to these, the impedance measuring device 5 includes the diagnosis elements 561 and 562 and the switching unit 570. The diagnosis element 561 has the resistance of the predetermined reference value Refl, and the diagnosis element 562 has the resistance of the predetermined reference value Ref2. The switching unit 570 is alternately switched to the battery connection state for measuring the internal resistances R1 and R2 of the fuel cell stack 1 and the element connection state for measuring the resistances of the diagnosis elements 561 and 562 in accordance with the control of the switch control unit 580.

The battery connection state of the switching unit 570 is a connection state where the positive-electrode side power supply unit 531 is connected to the positive electrode terminal 211 and the positive-electrode side detection unit 521 is connected to the positive electrode terminal 211 of the fuel cell stack 1, and the negative-electrode side power supply unit 532 is connected to the negative electrode terminal 212 and the negative-electrode side detection unit 522 is connected to the negative electrode terminal 212.

The element connection state of the switching unit 570 is a state where the positive-electrode side power supply unit 531 is cut off from the positive electrode terminal 211 and connected to the diagnosis element 561 and the positive-electrode side detection unit 521 is connected to the diagnosis element 561, and the negative-electrode side power supply unit 532 is cut off from the negative electrode terminal 212 and connected to the diagnosis element 562 and the negative-electrode side detection unit 522 is connected to the diagnosis element 562.

If the switching unit 570 is switched to the element connection state, the computation unit 550 computes the resistances of the diagnosis elements 561 and 562 on the basis of the alternating-current potential differences V1 and V2 and the alternating currents I1 and 12. Then, the computation unit 550 calculates differences between the computational values of the resistances of the diagnosis elements 561 and 562 and the reference values Ref1 and Ref2 as the measurement errors and diagnoses on the basis of the measurement errors of the diagnosis elements 561 and 562 whether or not the measurement state of the impedance measuring device 5 is good.

For example, the computation unit 550 judges that the measurement state is good if the measurement errors of the diagnosis elements 561 and 562 are within the predetermined allowable error range and judges that the measurement state is bad if the measurement error(s) is/are beyond the allowable error range.

As just described, if the measurement state of the impedance measuring device 5 is diagnosed to be bad, it is possible to output the diagnosis result together with the measurement value of the internal resistance R, stop the output of the measurement values and fix the measurement values immediately before judgement to the effect that the measurement state is bad as the measurement result. Since the measurement result satisfying the required measurement accuracy is output in this way, the reliability of the measurement result can be ensured.

Alternatively, the computation unit 550 computes the internal resistances R1 and R2 of the fuel cell stack 1 and corrects the computational values of the internal resistances R1 and R2 on the basis of the measurement errors of the diagnosis elements 561 and 562 when the switching unit 570 is switched to the battery connection state.

For example, the measurement values of the internal resistances R1 and R2 of the fuel cell stack 1 are corrected by subtracting the measurement error of the diagnosis element 561 or 562 therefrom. Thus, even if the measurement state is bad, the measurement result satisfying the required measurement accuracy can be output.

As just described, according to the present embodiment, reliability for the measurement result can be maintained and improved when the measurement accuracy of the impedance measuring device 5 is reduced due to the manufacturing variations, deterioration with time and the like of the electronic components such as the positive-electrode side power supply unit 531 and the positive-electrode side detection unit 521.

It should be noted that although an example in which the diagnosis elements 561 and 562 are respectively mounted in two systems of the measurement path on the positive electrode side and the measurement path on the negative electrode side has been described in the present embodiment, measurement errors due to the electronic components in the both measurement paths may be diagnosed by sharing one diagnosis element. In this case, in the element connection state, the positive-electrode side power supply unit 531 and the positive-electrode side detection unit 521, and the negative-electrode side power supply unit 532 and the negative-electrode side detection unit 522 are connected in turn to one diagnosis element.

For example, in the element connection state, the switch control unit 580 cuts off connection to the positive electrode terminal 211 and connects the positive-electrode side power supply unit 531 and the positive-electrode side detection unit 521 to one diagnosis element. Thereafter, connection to the negative electrode terminal 212 is cut off and the negative-electrode side power supply unit 532 and the negative-electrode side detection unit 522 are connected to the same diagnosis element.

Since variations between the systems on the positive electrode side and the negative electrode side, specifically an error caused by variations of the diagnosis element and the switchers, are eliminated in this way, accuracy in measuring the measurement error can be enhanced in each system.

Further, in the present embodiment, the computation unit 550 outputs the diagnosis execution signal to the switch control unit 580 to diagnose the measurement accuracy of the impedance measuring device 5 during the manufacturing, shipment inspection and regular inspection of the impedance measuring device 5. This causes the switching unit 570 to be switched to the element connection state by the switch control unit 580, and the measurement errors of the impedances of the diagnosis elements 561 and 562 are calculated by the computation unit 550.

Normally, an operator conducts the shipment inspection and calibration of the impedance measuring device 5 using an adjustment facility to adjust the manufacturing variations of the impedance measuring device 5 within allowable ranges. In contrast, the acceptance determination of the shipment inspection and regular inspection and the calibration of a measuring function can be automatically conducted by programming the computation unit 550 such that the diagnosis execution signal is output to the switch control unit 580 during the manufacturing, shipment inspection and regular inspection of the impedance measuring device 5.

For example, the diagnosis execution signal is output from the operation switch unit 61 shown in FIG. 2. The operation switch unit 61 are composed of switches or buttons operable from outside. The operation switch unit 61 includes an inspection switch for executing the diagnosis and calibration (correction) of the impedance measuring device 5. When the inspection switch is set ON by an operator, the diagnosis execution signal is output from the operation switch unit 61 to the control unit 6. The control unit 6 outputs the diagnosis execution signal to the switch control unit 580 via the computation unit 550 as shown in FIG. 10.

By doing so, it is possible to reduce an adjustment operation during manufacturing and a regular inspection operation while maintaining the measurement accuracy of the impedance measuring device 5. It should be noted that the diagnosis execution signal may be output from the operation switch unit 61 by attaching and detaching a jumper line to and from the operation switch unit 61.

Further, the computation unit 550 may output the diagnosis execution signal to the switch control unit 580 using a timing when the impedance measuring device 5 is started or stopped or when the fuel cell system is started or stopped as the diagnosis timing. The fuel cell system is a system for causing the fuel cell stack 1 to generate power by supplying anode gas and cathode gas to the fuel cell stack 1.

In this case, a start switch for starting the impedance measuring device 5 and a start switch for starting the fuel cell system are provided in the operation switch unit 61, and the control unit 6 outputs the diagnosis execution signal to the computation unit 550 when any of the start switches of the operation switch unit 61 is set ON. Alternatively, the control unit 6 may output the diagnosis execution signal to the computation unit 550 also when the start switch is switched from ON to OFF.

By doing so, a reduction of the measurement accuracy due to the deterioration with time of the impedance measuring device 5 can be detected early and the measurement values can be corrected in accordance with the deterioration with time of the electronic components.

Alternatively, the computation unit 550 may output the diagnosis execution signal to the switch control unit 580 at every predetermined operation time. In this case, the computation unit 550 includes a measurement counter for measuring an operation time of the impedance measuring device 5, and outputs the diagnosis execution signal, resets a count value and starts the counting of the measurement counter when the count value of that measurement counter reaches a prescribed value.

By doing so, the impedance measuring device 5 is regularly diagnosed and calibrated. Thus, the detection of a reduction of the measurement accuracy and the calibration in accordance with the deterioration with time can be more reliably conducted. Therefore, the reliability of the impedance measuring device 5 is improved. It should be noted that the measurement counter mounted in the computation unit 550 may be mounted in the control unit 6.

(Second Embodiment)

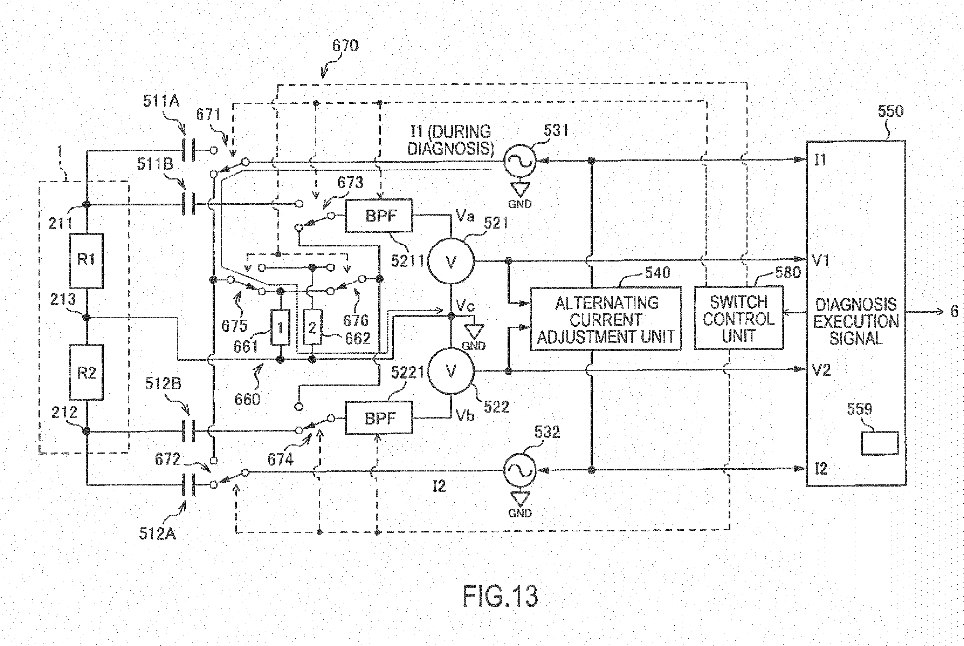

FIG. 13 is a diagram showing the configuration of an impedance measuring device in a second embodiment of the present invention.

The impedance measuring device of the present embodiment includes a diagnosis element unit 660 and a switching unit 670 instead of the diagnosis element unit 560 and the switching unit 570 of the impedance measuring device 5 shown in FIG. 10. Since the other constituent parts are the same as those of the impedance measuring device 5, they are denoted by the same reference signs and not described in detail.

The diagnosis element unit 660 is arranged at a position where it can be shared by two systems of a measurement path from a positive-electrode side power supply unit 531 to a positive-electrode side detection unit 521 and a measurement path from a negative-electrode side power supply unit 532 to a negative-electrode side detection unit 522.

The diagnosis element unit 660 includes a first diagnosis element 661 and a second diagnosis element 662. The diagnosis elements 661 and 662 are impedance elements having mutually different resistance values. The diagnosis element 661 has a resistance of a predetermined reference value Ref1. The diagnosis element 662 has a resistance of a predetermined reference value Ref2.

In the present embodiment, the reference value Ref11 is set at a lower limit value of a variable range of internal resistances R1 and R2 of a fuel cell stack 1. The reference value Ref12 is set at an upper limit value of the variable range of the internal resistances R1 and R2 of the fuel cell stack 1.

The switching unit 670 is alternately switched to a battery connection state for measuring the internal resistances R1 and R2 of the fuel cell stack 1 and an element connection state for measuring resistances of the diagnosis elements 661 and 662 in accordance with a control of a switch control unit 580.

In the battery connection state, the switching unit 670 connects the positive-electrode side power supply unit 531 to a positive electrode terminal 211 and connects the positive-electrode side detection unit 521 in parallel to the internal resistance R1 of the fuel cell stack 1. The switching unit 670 connects the negative-electrode side power supply unit 532 to a negative electrode terminal 212 and connects the negative-electrode side detection unit 522 in parallel to the internal resistance R2 of the fuel cell stack 1.

On the other hand, in the element connection state, the switching unit 670 is switched to a negative-electrode side measurement state for measuring an error of the measurement path from the negative-electrode side power supply unit 532 to the negative-electrode side detection unit after setting a positive-electrode side measurement state for measuring an error of the measurement path from the positive-electrode side power supply unit 531 to the positive-electrode side detection unit 521.

In the positive-electrode side measurement state and the negative-electrode side measurement state, the switching unit 670 is switched to a measurement path for measuring the resistance of the second diagnosis elements 662 after being connected to a measurement path for measuring the resistance of the first diagnosis elements 661.

In the present embodiment, the switching unit 670 includes current path switchers 671 and 672, detection object switchers 673 and 674 and diagnosis element switchers 675 and 676. These are realized, for example, by analog switches or relays.

The current path switcher 671 is connected between the positive-electrode side power supply unit 531 and a capacitor 511A. The current path switcher 671 switches a supply destination of an alternating current I1 output from the positive-electrode side power supply unit 531 to the positive electrode terminal 211 of the fuel cell stack 1 or the diagnosis element switcher 675.

In the current path switcher 671, an input terminal is connected to the positive-electrode side power supply unit 531, a first output terminal is connected to the capacitor 511A and a second output terminal is connected to an input terminal of the diagnosis element switcher 675.

The current path switcher 672 is connected between the negative-electrode side power supply unit 532 and a capacitor 512A. The current path switcher 672 switches a supply destination of an alternating current I2 output from the negative-electrode side power supply unit 532 to the negative electrode terminal 212 of the fuel cell stack 1 or the diagnosis element switcher 675.

In the current path switcher 672, an input terminal is connected to the negative-electrode side power supply unit 532, a first output terminal is connected to the capacitor 512A and a second output terminal is connected to the input terminal of the diagnosis element switcher 675.

The detection object switcher 673 is connected between the capacitor 511B and a band-pass filter 5211. The detection object switcher 673 switches a detection object to be connected in parallel to the positive-electrode side detection unit 521 to a positive-electrode side part of the fuel cell stack 1 or the diagnosis element switcher 676.

In the detection object switcher 673, a first input terminal is connected to the capacitor 511B, a second input terminal is connected to an input terminal of the diagnosis element switcher 676 and an output terminal is connected to the band-pass filter 5211.

The detection object switcher 674 is connected between a capacitor 512B and a band-pass filter 5221. The detection object switcher 674 switches a detection object to be connected in parallel to the negative-electrode side detection unit 522 to a negative-electrode side part of the fuel cell stack 1 or the diagnosis element switcher 676.

In the detection object switcher 674, a first input terminal is connected to the capacitor 512B, a second input terminal is connected to the input terminal of the diagnosis element switcher 676 and an output terminal is connected to the band-pass filter 5221.

The diagnosis element switcher 675 is connected between a current signal line connecting between the current path switchers 671 and 672 and the diagnosis element unit 660. The diagnosis element switcher 675 switches a supply destination of the alternating current I1 or I2 output from the current path switcher 671 or 672 to the diagnosis element 661 or 662.

In the diagnosis element switcher 675, an input terminal is connected to the second output terminal of the current path switcher 671 and the second output terminal of the current path switcher 672, a first output terminal is connected to the diagnosis element 661 and a second output terminal is connected to the diagnosis element 662.

The diagnosis element switcher 676 is connected between a detection signal line connecting between the detection object switchers 673 and 674 and the diagnosis element unit 660. The diagnosis element switcher 676 switches a detection object whose alternating-current potential difference is to be detected by the positive-electrode side detection unit 521 or the negative-electrode side detection unit 522 to the first diagnosis element 661 or the second diagnosis element 662.

In the diagnosis element switcher 676, a first input terminal is connected to the diagnosis element 661, a second input terminal is connected to the diagnosis element 662 and an output terminal is connected to the second input terminal of the detection object switcher 673 and the second input terminal of the detection object switcher 674.

The current path switchers 671 and 672, the detection object switchers 673 and 674 and the diagnosis element switchers 675 and 676 described above are respectively controlled by the switch control unit 580.

The switch control unit 580 switches a connection state of the measurement path of the switching unit 670 to the battery connection state or the element connection state when a predetermined diagnosis timing is reached.

In the battery connection state, the switch control unit 580 controls the current path switcher 671 to connect the positive-electrode side power supply unit 531 to the capacitor 511A and controls the current path switcher 672 to connect the negative-electrode side power supply unit 532 to the capacitor 512A. Along with this, the switch control unit 580 controls the detection object switcher 673 to connect the band-pass filter 5211 of the positive-electrode side detection unit 521 to the capacitor 511B and controls the detection object switcher 674 to connect the band-pass filter 5221 of the negative-electrode side detection unit 522 to the capacitor 512B.

In the element connection state, the switch control unit 580 sets the switching unit 670 to the positive-electrode side measurement state for measuring a measurement error generated in the measurement path from the positive-electrode side power supply unit 531 to the positive-electrode side detection unit 521 as shown in FIG. 13.

Specifically, the switch control unit 580 controls the current path switcher 671 to switch the positive-electrode side power supply unit 531 to the input terminal of the diagnosis element switcher 675 and controls the current path switcher 672 to keep the positive-electrode side power supply unit 532 connected to the capacitor 512A. Along with this, the switch control unit 580 controls the detection object switcher 673 to switch the band-pass filter 5211 to the output terminal of the diagnosis element switcher 676 and controls the detection object switcher 674 to keep the band-pass filter 5221 connected to the capacitor 512B.

Then, the switch control unit 580 sets the connection state of the switching unit 670 to the one for measuring the resistance of the first diagnosis element 661. Specifically, the switch control unit 580 controls the diagnosis element switcher 675 to connect the positive-electrode side power supply unit 531 to the diagnosis element 661 and controls the diagnosis element switcher 676 to connect the positive-electrode side detection unit 521 to the diagnosis element 661. In this state, the alternating-current potential difference V1 is adjusted to the reference voltage Vs by an alternating current adjustment unit 540 and the resistance R1 of the diagnosis element 661 is measured on the basis of the alternating current I1 and the alternating-current potential difference V1 by a computation unit 550.

Thereafter, the switch control unit 580 switches the connection state of the switching unit 670 to the one for measuring the resistance of the second diagnosis element 662.

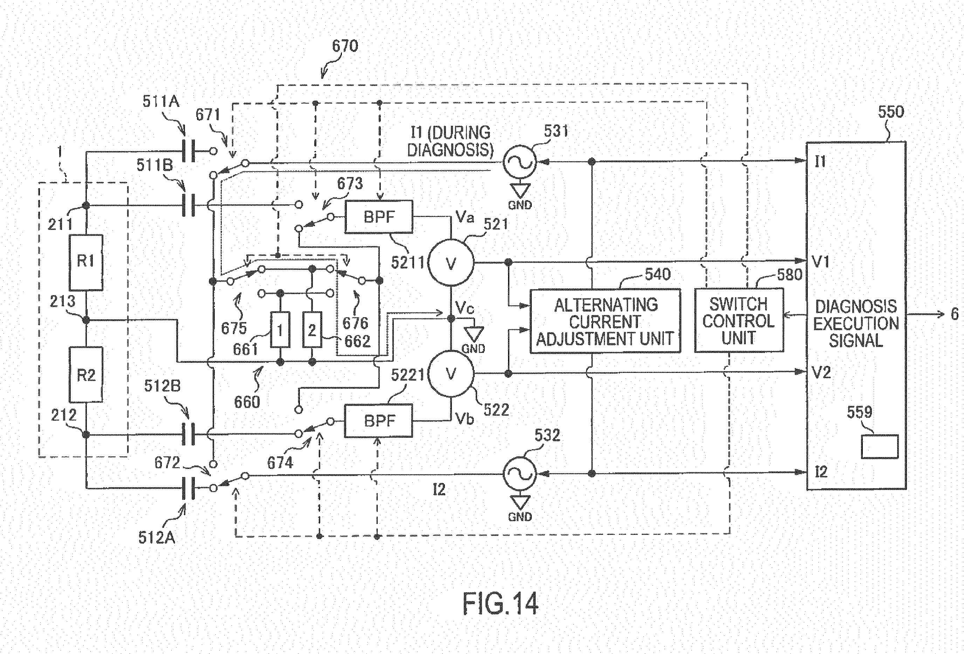

FIG. 14 is a diagram showing the connection state in the impedance measuring device 5 when the resistance of the second diagnosis element 662 is measured in the element connection state.

As shown in FIG. 14, the switch control unit 580 controls the diagnosis element switcher 675 to connect the positive-electrode side power supply unit 531 to the diagnosis element 662 and controls the diagnosis element switcher 676 to connect the positive-electrode side detection unit 521 to the diagnosis element 662. In this state, the alternating-current potential difference V1 is adjusted to the reference voltage by the alternating current adjustment unit 540 and the resistance R1 of the diagnosis element 662 is measured on the basis of the alternating current I1 and the alternating-current potential difference V1 by the computation unit 550.

Subsequently, the switch control unit 580 switches the connection state of the switching unit 670 to the negative-electrode side measurement state for measuring a measurement error generated in the measurement path from the negative-electrode side power supply unit 532 to the negative-electrode side detection unit 522.

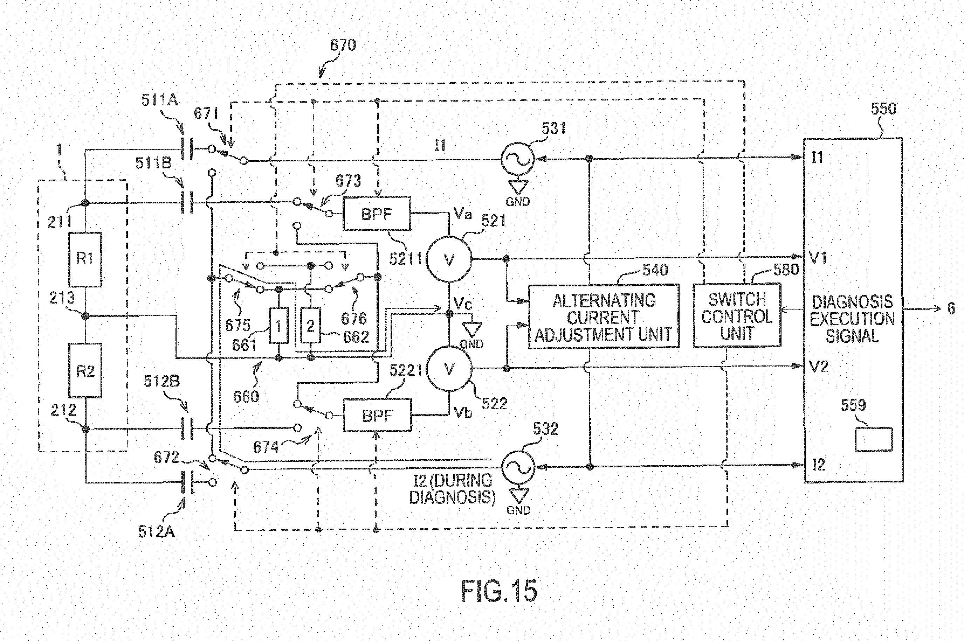

FIG. 15 is a diagram showing the connection state for measuring the measurement error generated in the measurement path on the negative electrode side in the element connection state. Here, the connection state for measuring the resistance of the first diagnosis element 661 is shown. Since the diagnosis elements 661 and 662 are connected in turn as shown in FIGS. 13 and 14 also for diagnoses on the negative electrode side, the resistance of the diagnosis element 662 is measured after the resistance of the diagnosis element 661 is measured by the computation unit 550.

Then, the computation unit 550 computes, for example, an error characteristic of the measurement paths on the positive electrode side and the negative electrode side using the measurement values of the diagnosis elements 661 and 662 having mutually different resistance values and the reference values Ref11 and Ref12. The computation unit 550 corrects the measurement values of the internal resistances R1 and R2 of the fuel cell stack 1 using that error characteristic.

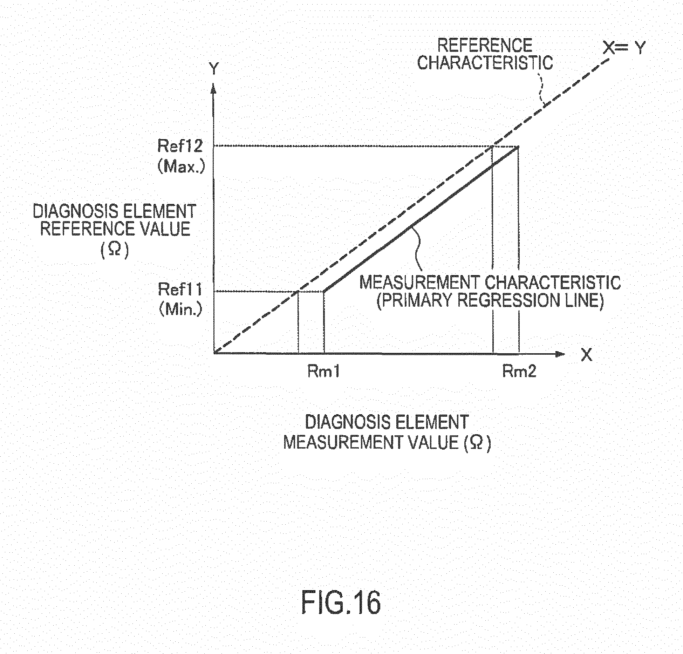

FIG. 16 is a graph showing an example of a correction technique for correcting the internal resistances R1 and R2 computed by the computation unit 550.

FIG. 16 shows a reference characteristic indicating true values of the resistances of the diagnosis elements 661 and 662 and a measurement characteristic determined by the measurement values of the resistances of the diagnosis elements 661 and 662. In FIG. 16, a vertical axis (Y) shows the reference values Ref11 and Ref12 of the diagnosis elements 661 and 662 and a horizontal axis (X) shows measurement values Rm1 and Rm2 of the resistances of the diagnosis elements 661 and 662.

The computation unit 550 computes a correction characteristic for correcting an error characteristic of the impedance measuring device 5 on the basis of the reference characteristic and the measurement characteristic. The error characteristic is a characteristic indicating a measurement error which changes according to the magnitude of the resistance to be measured, and the correction characteristic is a characteristic indicating a correction amount of the measurement error which changes according to the magnitude of the resistance to be measured. In the present embodiment, the error characteristic and the correction characteristic are approximated by primary regression lines.

Specifically, the computation unit 550 calculates a gradient Ka and an intercept Kb of an approximation straight line approximating the correction characteristic using the reference values Ref11 and Ref12 of the diagnosis elements 661 and 662 and the measurement values Rm1 and Rm2 of the diagnosis elements 661 and 662.

[Equations 2]

$$Ka = \frac{Ref12 - Ref11}{Rm2 - Rm1} \quad \ldots (2\text{-}1)$$

$$Kb = Ref11 - Rm1 * Ka \quad \ldots (2\text{-}2)$$

Then, the computation unit 550 records the calculated gradient Ka and intercept Kb as correction coefficients in a memory 559. By computing the gradient Ka and the intercept Kb of the straight line approximating the correction characteristic in this way, the correction characteristic in which the correction amount changes according to the magnitude of the measurement value can be obtained.

If the switching unit 670 is switched to the battery connection state after the diagnosis of the impedance measuring device 5, the computation unit 550 computes the internal resistances R1 and R2 of the fuel cell stack 1 in accordance with equation (1-1). Then, the computation unit 550 calculates measurement values Rc of the internal resistances R1 and R2 after the correction by correcting the computed measurement values Rm of the internal resistances R1 and R2 using the gradient Ka and the intercept Kb of the correction characteristic as shown in the following equation.

[Equation 3]

$$Rc = Rm * Ka + Kb \quad \ldots (3)$$

As just described, the computation unit 550 measures the resistances of the diagnosis elements 661 and 662 and computes the correction characteristic for correcting the measurement errors according to the measurement values of the internal resistances R1 and R on the basis of two measurement errors. After the diagnosis, the impedance measuring device 5 measures the internal resistances R1 and R2 of the fuel cell stack 1 and corrects the measurement errors that change according to variations of the internal resistances R1 and R2 on the basis of the measurement values Rm of the internal resistances R1 and R2 and the correction characteristic computed during diagnosis. In this way, the measurement values Rc of the internal resistances R1 and R2 are calculated.

Further, in the present embodiment, the resistances of the diagnosis elements 661 and 662 are respectively set at the upper limit value and the lower limit value of the variable range of the internal resistances R1 and R2 of the fuel cell stack 1. Since this causes the error characteristic or the correction characteristic to be more accurately approximated in the variation range of the internal resistances R1 and R2, errors of the measurement values Rc of the internal resistances R1 and R2 can be reduced.

Further, although an example in which the primary regression line is computed using the measurement errors of two diagnosis elements to approximate the correction characteristic has been described in the present embodiment, three or more diagnosis elements may be provided in the impedance measuring device 5 and a primary regression line may be computed using measurement errors of these diagnosis elements. In this case, since the error characteristic and the correction characteristic are more accurately computed, errors of the measurement values output from the computation unit 550 can be made smaller.

Further, although an example in which the primary regression line is computed on the basis of the measurement errors of the two diagnosis elements has been described in the present embodiment, approximation curves may be computed if the error characteristic and the correction characteristic are more accurately represented by the approximation curves than the primary regression lines. For example, an approximation equation for a curve determined by experimental data or the like is obtained in advance and a coefficient of that approximation equation is computed on the basis of measurement errors of two or more diagnosis elements. In this way, the error characteristic and the correction characteristic that change according to the resistance values can be more accurately approximated.

Further, the impedance measuring device 5 of the present embodiment has a circuit configuration doubling as the diagnosis elements 661 and 662 to detect the measurement errors of the two systems of the measurement path on the positive electrode side and the measurement path on the negative electrode side.

Since this causes variations of the diagnosis elements and switchers between the two systems to be eliminated in the case of detecting the measurement errors of the systems or in the case of computing the correction coefficient for correcting the measurement errors, accuracy in measuring the measurement errors can be enhanced. Further, since the number of the switchers can be reduced by adopting the circuit configuration doubling as the diagnosis elements 661 and 662, the small-size impedance measuring device 5 can be inexpensively realized. Thus, it is possible to inexpensively miniaturize the circuit configuration of the impedance measuring device 5 while improving the measurement accuracy of the internal resistance of the fuel cell stack 1.

It should be noted that, in the present embodiment, a voltage signal generation circuit for generating voltage signals simulating output signals respectively output from the positive electrode terminal 211 and the negative electrode terminal 212 of the fuel cell stack 1 may be provided in the impedance measuring device 5 instead of the diagnosis elements 661 and 662. Even in such a configuration, effects similar to those of the present embodiment are obtained. However, the voltage signals generated from the voltage signal generation circuit need to be synchronized in phase with alternating-current signals used in positive-electrode side detector circuits 5411 and negative-electrode side detector circuits 5412.

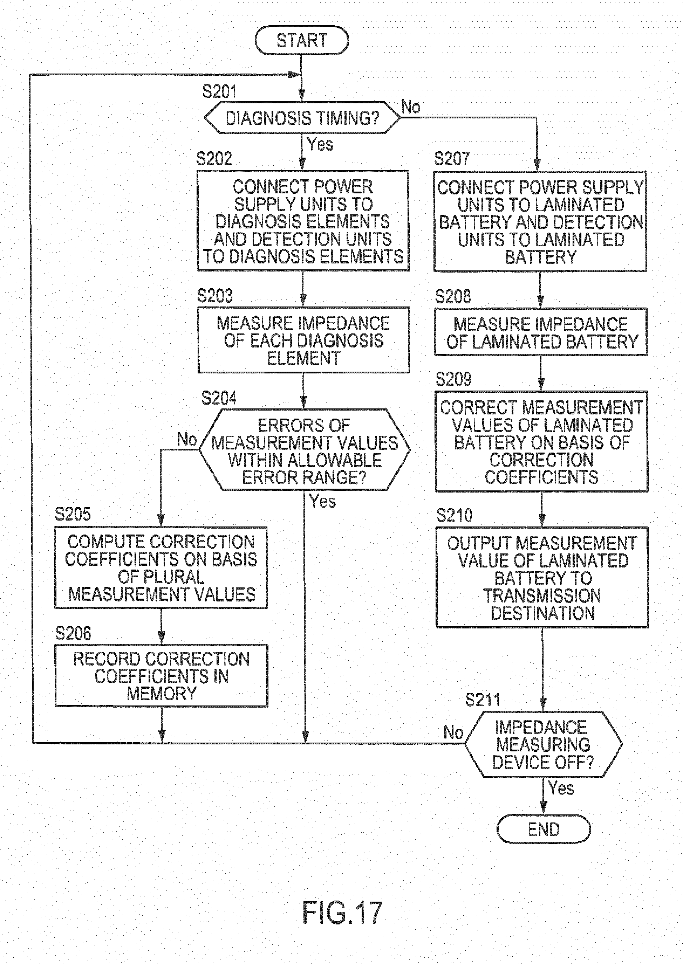

FIG. 17 is a flow chart of an example of an impedance measuring method in the present embodiment.

First, in Step S201, the computation unit 550 judges whether or not the impedance measuring device 5 has reached a diagnosis timing for diagnosing the measurement state of its own. The computation unit 550 supplies a diagnosis execution signal to the switch control unit 580 in the case of judging that the diagnosis timing has been reached while stopping the supply of the diagnosis execution signal to the switch control unit 580 in the case of judging that the diagnosis timing has not been reached.

In Step S202, the switch control unit 580 connects the positive-electrode side power supply unit 531 to the diagnosis element unit 660 and connects the positive-electrode side detection unit 521 to the diagnosis element unit 660 when receiving the diagnosis execution signal from the computation unit 550. Specifically, the switch control unit 580 connects the diagnosis element unit 660 to the measurement path from the positive-electrode side power supply unit 531 to the positive-electrode side detection unit 521.

In Step S203, the switch control unit 580 connects the diagnosis elements 661 and 662 in the diagnosis element unit 660 in turn to the measurement path from the positive-electrode side power supply unit 531 to the positive-electrode side detection unit 521 and the computation unit 550 measures the resistance of each of the diagnosis elements 661 and 662.

Specifically, the switch control unit 580 supplies the alternating current I1 output from the positive-electrode side power supply unit 531 to the diagnosis element 661 and outputs the alternating-current potential difference V1 generated in the diagnosis element 661 to the positive-electrode side detection unit 521. Then, the computation unit 550 calculates the measurement value Rm1 of the resistance of the diagnosis element 661 using the alternating current I1 and the alternating-current potential difference V1 adjusted by the alternating current adjustment unit 540.

Thereafter, the switch control unit 580 supplies the alternating current I1 output from the positive-electrode side power supply unit 531 to the diagnosis element 662 and outputs the alternating-current potential difference V1 generated in the diagnosis element 662 to the positive-electrode side detection unit 521. Then, the computation unit 550 calculates the measurement value Rm2 of the resistance of the diagnosis element 662 using the alternating current I1 and the alternating-current potential difference V1 adjusted by the alternating current adjustment unit 540.

Similarly, the switch control unit 580 connects the diagnosis elements 661 and 662 in turn to the measurement path from the negative-electrode side power supply unit 532 to the negative-electrode side detection unit 522 and the computation unit 550 measures the resistance of each of the diagnosis elements 661 and 662.

Then, the computation unit 550 calculates the measurement error between the measurement value Rm1 of the diagnosis element 661 and the reference value Ref11 and the measurement error between the measurement value Rm2 of the diagnosis element 662 and the reference value Ref12 for each of the measurement paths on the positive electrode side and the negative electrode side.

In Step S204, the computation unit 550 judges whether or not the measurement error of each of the diagnosis elements 661 and 662 in the measurement path on the positive electrode side and the measurement error of each of the diagnosis elements 661 and 662 in the measurement path on the negative electrode side are within an allowable error range.

The computation unit 550 returns to Step S201 if all the four measurement errors are within the allowable error range. On the other hand, the computation unit 550 proceeds to Step S205 if any of the four measurement errors is outside the allowable error range.

In Step S205, the computation unit 550 computes a correction coefficient on the positive electrode side on the basis of the measurement error of the measurement value Rm1 of the diagnosis element 661 and the measurement error of the measurement value Rm2 of the diagnosis element 662 in the measurement path on the positive electrode side. Further, the computation unit 550 computes a correction coefficient on the negative electrode side on the basis of the measurement error of the measurement value Rm1 of the diagnosis element 661 and the measurement error of the measurement value Rm2 of the diagnosis element 662 in the measurement path on the negative electrode side.

Specifically, the computation unit 550 calculates the gradient Ka and the intercept Kb of the straight line approximating the correction characteristic as the correction coefficients as in equations (2-1) and (2-2).

In Step S206, the computation unit 550 records the gradient Ka and the intercept Kb of the straight line approximating the correction characteristic on the positive electrode side and the gradient Ka and the intercept Kb of the straight line approximating the correction characteristic on the negative electrode side in the memory 559.

If it is judged in Step S201 that the impedance measuring device 5 has not reached the diagnosis timing, the computation unit 550 stops the supply of the diagnosis execution signal to the switch control unit 580.

In Step S207, the switch control unit 580 supplies the alternating currents I1 and I2 to the internal resistances R1 and R2 of the fuel cell stack 1 and switches the connection state to the battery connection state where the alternating-current potential differences V1 and V2 generated in the internal resistances R1 and R2 can be detected. Then, the alternating-current potential differences V1 and V2 generated in the internal resistances R1 and R2 of the fuel cell stack 1 are output to the computation unit 550 from the positive-electrode side detection unit 521 and the negative-electrode side detection unit 522 with the amplitudes of the alternating currents I1 and I2 adjusted by the alternating current adjustment unit 540.

In Step S208, the computation unit 550 computes the internal resistances R1 and R2 of the fuel cell stack 1 using the alternating currents I1 and I2 and the alternating-current potential differences V1 and V2 after the adjustment as in equation (1-1). Specifically, the computation unit 550 measures the internal impedance of the fuel cell stack 1.

In Step S209, the computation unit 550 corrects the measurement values Rm of the internal resistances R1 and R2 of the fuel cell stack 1 using the correction coefficients stored in the memory 559. Specifically, the computation unit 550 computes the measurement values Rc after the correction by correcting the measurement values Rm of the internal resistances R1 and R2 using the gradients Ka and the intercepts Kb as in equation (3).

In Step S210, the computation unit 550 computes the internal resistance R of the entire fuel cell stack 1 by combining the measurement values Rc of the internal resistances R1 and R2 of the fuel cell stack 1, and transmits that internal resistance R as a measurement result to the control unit 6 as a transmission destination.

In Step S211, the computation unit 550 repeats a series of processings in Steps S201 to S210 until the impedance measuring device 5 is stopped (OFF) and ends a diagnosing method when the impedance measuring device 5 is stopped.

According to the second embodiment of the present invention, the impedance measuring device 5 doubles as the diagnosis element unit 660 in the two systems of the measurement paths on the positive electrode side and the negative electrode side using the switching unit 670 unlike the first embodiment. The diagnosis element unit 660 includes the diagnosis elements 661 and 662 having the resistances of the mutually different reference values Ref11 and Ref12.

The switching unit 670 cuts off the connection of the impedance measuring device 5 and the fuel cell stack 1 and connects the diagnosis elements 661 and 662 in turn between the positive-electrode side power supply unit 531 and the positive-electrode side detection unit 521. Then, the measurement error between the reference value Ref11 of the diagnosis element 661 and the measurement value Rm1 of the positive-electrode side path and the measurement error between the reference value Ref12 of the diagnosis element 662 and the measurement value Rm2 of the positive-electrode side path are calculated by the computation unit 550.

The computation unit 550 computes the gradient Ka and the intercept Kb of the approximation equation for correcting each measurement error on the basis of the measurement error of each of the diagnosis elements 661 and 662 on the positive-electrode side path, and records these as the correction coefficients in the memory 559.

Similarly, the switching unit 670 connects the diagnosis elements 661 and 662 in turn between the negative-electrode side power supply unit 532 and the negative-electrode side detection unit 522 when being switched to the element connection state. Then, the measurement error between the reference value Ref11 of the diagnosis element 661 and the measurement value Rm1 of the negative-electrode side path and the measurement error between the reference value Ref12 of the diagnosis element 662 and the measurement value Rm2 of the negative-electrode side path are calculated by the computation unit 550.

Further, the computation unit 550 computes the gradient Ka and the intercept Kb of the approximation equation on the negative electrode side on the basis of the measurement error of each of the diagnosis elements 661 and 662 on the negative-electrode side path, and records these as the correction coefficients in the memory 559. For example, the computation unit 550 computes the primary regression line as the approximation equation in accordance with equations (2-1) and (2-2).

Thereafter, the computation unit 550 corrects the measurement values of the internal resistances R1 and R2 of the fuel cell stack 1 on the basis of the correction coefficients on the positive electrode side and the negative electrode sides in the memory 559 when the switching unit 670 is switched to the battery connection state for connecting the impedance measuring device 5 to the fuel cell stack 1.

For example, in accordance with equation (3), the computation unit 550 calculates the measurement value Rc of the internal resistance R1 after the correction using the measurement value Rm of the internal resistance R1 and the gradient Ka and the intercept Kb on the positive electrode side, and calculates the measurement value Rc of the internal resistance R2 after the correction using the measurement value Rm of the internal resistance R2 and the gradient Ka and the intercept Kb on the negative electrode side. Then, the computation unit 550 computes the internal resistance R of the entire fuel cell stack 1 by combining the measurement values Rc of the internal resistances R1 and R2 after the correction.

As just described, according to the second embodiment, the correction characteristic is computed on the basis of the measurement errors of two or more diagnosis elements having different resistance values. Thus, even in a circuit characteristic in which measurement errors change according to an impedance variation of a measurement object, measurement accuracy can be improved regardless of such a variation. Specifically, reliability for the measurement result of the impedance measuring device 5 can be more improved than in the first embodiment.

Further, in the present embodiment, the computation unit 550 may diagnose the measurement accuracy of the impedance measuring device 5 by outputting a diagnosis execution signal to the switch control unit 580 when receiving the diagnosis execution signal transmitted from the control unit 6.

For example, in the fuel cell stack 1 in which solid polymer fuel cells are laminated, the water content (electrical conductivity) of polymer membranes becomes too low and the fuel cells are dried if an operation is continued at a load higher than normal. Thus, power generation performance of the fuel cell stack 1 is deteriorated. Thus, in a continuously operating state at a high load, a degree of wetness of the polymer membranes needs to be estimated to prevent the deterioration of power generation performance of the fuel cell stack 1. Thus, measurement accuracy higher than normal is required for the impedance measuring device 5.

Accordingly, the control unit 6 transmits the diagnosis execution signal as a command signal for correcting the internal resistance R to the computation unit 550 when the fuel cell stack 1 is operated at a high load, e.g. when an output current or generated power of the fuel cell stack 1 exceeds a power generation threshold value. It should be noted that the power generation threshold value is a threshold value determined to determine whether or not a high-load operation is in execution.

The computation unit 550 outputs the diagnosis execution signal to the switch control unit 580 when receiving the diagnosis execution signal, whereby the switch control unit 580 switches the switching unit 670 to the element connection state for measuring the resistances of the diagnosis elements 661 and 662. Then, the computation unit 550 calculates the measurement errors of the diagnosis elements 661 and 662 and updates the correction coefficients in the memory 559 on the basis of these measurement errors.

Thereafter, the switching unit 670 is returned to the battery connection state for measuring the internal resistances R1 and R2 of the fuel cell stack 1 by the switch control unit 580, and the computation unit 550 corrects the measurement values of the internal resistances R1 and R2 on the basis of the correction coefficients updated during diagnosis.

This enables the impedance measuring device 5 to measure the internal resistance R of the fuel cell stack 1 with measurement accuracy corresponding to a request even if measurement accuracy requested from the control unit 6 increases according to the operating state of the fuel cell stack 1.

Further, the fuel cell stack 1 has electrical characteristics such as charge transfer resistance, electric double layer capacitance and internal loss resistance relating to the power generation of the fuel cells inside. Since an internal loss resistance component included in the internal impedance of the fuel cell stack 1 is highly correlated with a wet state of electrolyte membranes 111 in the present embodiment, the internal resistance R of the fuel cell stack 1 is measured by the impedance measuring device 5.

On the other hand, electrostatic capacitance components of a charge transfer resistance and an electric double layer capacitance included in the internal impedance of the fuel cell stack 1 can be measured by changing the frequencies of the alternating currents I1 and I2 supplied to the fuel cell stack 1.

The electrostatic capacitance component of the internal impedance changes according to a concentration of hydrogen contained in the anode gas in the fuel cell stack 1. Since the electrolyte membranes 111 are deteriorated if the hydrogen concentration in the fuel cell stack 1 is insufficient, a hydrogen shortage in the fuel cell stack 1 can be diagnosed by utilizing a measurement value of the electrostatic capacitance of the fuel cell stack 1.

To measure the electrostatic capacitance component of the internal impedance, the frequencies of the alternating currents I1 and I2 need to be set at frequencies lower than a reference frequency fb for the measurement of the internal resistance R and are preferably set at frequencies lower than 1 kHz.

To measure the internal resistance and the internal electrostatic capacitance of the fuel cell stack 1 in this way, it is necessary to adopt a circuit configuration capable of changing the frequencies of the alternating currents I1 and I2 output from the impedance measuring device 5 to the fuel cell stack 1.

For example, the alternating-current signal source 546 is replaced by an alternating-current signal source capable of changing frequencies, and each of the band-pass filters 5211 and 5222 is provided with a band-pass filter for measuring the electrostatic capacitance separately from a band-pass filter for measuring the internal resistance and a filter switch for switching the both.

In such a circuit configuration, the control unit 6 outputs a frequency change command signal for changing the frequencies of the alternating currents I1 and I2 to the computation unit 550 of the impedance measuring device 5 according to the operating state of the fuel cell stack 1.

For example, the control unit 6 outputs the frequency change command signal to the computation unit 550 when the generated power of the fuel cell stack 1 largely changes and when a stopping process of the fuel cell stack 1 is to be performed, i.e. when there is a possibility that hydrogen lacks in the fuel cell stack 1.

Then, the computation unit 550 supplies the frequency change command signal to the switch control unit 580. This causes the switch control unit 580 to change the frequency of the alternating-current signal source provided in the alternating current adjustment unit 540 and capable of changing frequencies to a designated frequency indicated by the frequency change command signal. Along with this, the switch control unit 580 controls the band-pass filters 5211 and 5221 as shown in FIGS. 10, 13 and the like to switch the filter switcher to the band-pass filter corresponding to the designated frequency indicated by the frequency change command signal. At this time, signal transmission sensitivity and phase shift amounts of the positive-electrode side detection unit 521 and the negative-electrode side detection unit 522 change due to frequency characteristics of the positive-electrode side detection unit 521 and the negative-electrode side detection unit 522.

As a measure against this, the computation unit 550 outputs a diagnosis execution signal to the switch control unit 580 after setting the frequencies of the alternating currents I1 and I2 according to the frequency change command signal when receiving the frequency change command signal from the control unit 6.

In this way, a reduction of the measurement accuracy due to changes of the frequency characteristics of the positive-electrode side detection unit 521 and the negative-electrode side detection unit 522 associated with the frequency changes of the alternating currents I1 and I2. Accordingly, constant measurement accuracy can be ensured in the entire measurement frequency range of the alternating currents I1 and I2. In this example, the impedance measuring device 5 measures the resistance component and the electrostatic capacitance component of the fuel cell stack 1. Thus, by using impedance elements, in which resistance elements and capacitor elements are connected in parallel, as the diagnosis elements, the resistance component and the electrostatic capacitance component can be diagnosed by a simple circuit configuration as compared to a circuit configuration in which the resistance elements and the capacitor elements are separately provided and switched by switchers.

Further, in the present embodiment, the computation unit 550 may transmit the measurement value of the internal resistance R measured immediately before the diagnosis as a measurement result to the control unit 6 together with a status signal to the effect that the diagnosis is in execution while the measurement state is being diagnosed in the impedance measuring device 5. This enables the control unit 6 to continue the control of the wet state of the fuel cell stack 1.

Further, the control unit 6 may limit the generated power of the fuel cell stack 1 within a predetermined range if an accelerator pedal is depressed by a driver and an increase of the generated power is requested from the load 3 while the status signal to the effect that the diagnosis is in execution is being received. This can avoid a reduction in power generation performance, for example, in a state where the fuel cell stack 1 is likely to be dried.

Further, in the present embodiment, the computation unit 550 may diagnose the measurement state of the impedance measuring device 5 by outputting the diagnosis execution signal to the switch control unit 580 according to a temperature of the fuel cell stack 1 or ambient temperature.

The internal resistance R of the fuel cell stack 1 changes according to the temperature of the fuel cell stack 1 or ambient temperature. For example, in a sub-zero environment lower than a freezing point temperature, produced water in the fuel cell stack 1 becomes ice and intervals between the power generation cells 10 are widened by that ice and the internal resistance R increases, for example, to about 100 mΩ.

On the other hand, since electrical conductivity is increased by heat generation associated with the discharge of the laminated battery and water produced in the fuel cell stack 1 during the travel of a vehicle, the internal resistance R of the fuel cell stack 1 may be reduced to 1/10 as compared to that in the sub-zero environment.

As just described, since the internal resistance R changes to become larger as a temperature change of the fuel cell stack 1 becomes larger, the alternating currents I1 and I2 are largely changed by an equipotential control and characteristics of the electronic components such as the positive-electrode side power supply unit 531 and the positive-electrode side detection unit 521 also change. As just described, as a temperature change of the fuel cell stack 1 increases, the measurement error of the impedance measuring device 5 becomes larger. Thus, the measurement accuracy of the impedance measuring device 5 is largely reduced in such a situation where the temperature of the fuel cell stack 1 or ambient temperature largely suddenly changes.

As a measure against this, the computation unit 550 may output the diagnosis execution signal to the switch control unit 580 every time the temperature of the fuel cell stack 1 or ambient temperature exceeds a temperature threshold value set in a stepwise manner.

Specifically, a plurality of temperature threshold values set for each prescribed value temperature range are recorded in the memory 559. The temperature range is determined by a temperature coefficient of an electronic circuit and the like. For example, when the temperature range is set at 25°C, a first temperature threshold value is set at -25°C, a second temperature threshold value is set at 0°C, a third temperature threshold value is set at 25°C and a fourth temperature threshold value is set at 50°C.

Further, since the resistances of the diagnosis elements 661 and 662 also change as the temperature changes of the diagnosis elements 661 and 662 increase, temperature characteristic information indicating a characteristic of resistance values corresponding to the temperatures of the diagnosis elements 661 and 662 is recorded in the memory 559.

The computation unit 550 obtains the ambient temperature of the fuel cell stack 1 from the temperature sensor 62 via the control unit 6 as shown in FIG. 2. The computation unit 550 outputs the diagnosis execution signal to the switch control unit 580 when that ambient temperature of the fuel cell stack 1 reaches any of the first to fourth temperature threshold values.

Along with this, the computation unit 550 refers to the temperature characteristic information stored in the memory 559 and calculates the resistance values of the diagnosis elements 661 and 662 corresponding to the ambient temperature as the reference values Ref11 and Ref12. In this way, the reference values Ref11 and Ref12 of the diagnosis elements 661 and 662 are corrected.

Then, the computation unit 550 computes the resistances of the diagnosis elements 661 and 662, for example, on the basis of the alternating current I1 and the alternating-current potential difference V1 on the positive electrode side when the switching unit 670 is switched to the element connection state by the switch control unit 580. The computation unit 550 computes a correction coefficient for correcting the measurement errors on the positive electrode side using those measurement values of the resistances of the diagnosis elements 661 and 662 and the reference values Ref11 and Ref12 corrected by the ambient temperature of the fuel cell stack 1.

The computation unit 550 computes the internal resistance R1 of the fuel cell stack 1 when the switching unit 670 is switched to the battery connection state by the switch control unit 580 after the diagnosis process is finished. Then, the computation unit 550 corrects the measurement value Rm of the internal resistance R1 to the measurement value Rc as in equation (3) using the measurement value Rm of the internal resistance R1 and the correction coefficient computed during diagnosis.

It should be noted that, instead of the ambient temperature detected by the temperature sensor 62, a detection signal output from a cooling water temperature sensor (not shown) of the fuel cell stack 1 may be used as the temperature of the fuel cell stack 1. The cooling water temperature sensor is for detecting the temperature of cooling water flowing in the fuel cell stack 1.

As just described, by correcting the reference values Ref11 and Ref12 of the diagnosis elements 661 and 662 according to the ambient temperature of the diagnosis elements 661 and 662, the measurement errors of the diagnosis elements 661 and 662 can be accurately measured even if the ambient temperature largely changes.

The computation unit 550 updates the correction coefficient by performing the diagnosis process in such a state every time a variation width of the temperature of the fuel cell stack 1 or ambient temperature exceeds the prescribed value temperature range, whereby an increase of the measurement error of the internal resistance of the fuel cell stack 1 associated with a temperature change can be suppressed. Thus, the impedance measuring device 5 can maintain high measurement accuracy without using an expensive circuit having a small measurement error even in an environment where a temperature change is large.

As described above, in the case of limiting the generated power of the fuel cell stack 1, the control unit 6 may cause a display unit provided at a position seeable by a driver to display an indication to the effect that the generated power of the fuel cell stack 1 is limited. In this way, a sense of incongruity felt by the driver due to an insufficient response of the vehicle to a depressed amount of the accelerator pedal can be reduced. It should be noted that the display unit may be provided in the control unit 6.

Although the embodiments of the present invention have been described above, the above embodiments are merely some application examples of the present invention and not intended to limit the technical scope of the present invention to the specific configurations of the above embodiments.

For example, although an example in which the internal impedance of the fuel cell stack 1 is measured by the impedance measuring device 5 has been described in the above embodiments, it is sufficient that a measurement object is a laminated battery in which a plurality of battery cells are laminated and may, for example, a laminated lithium ion battery.

Further, in the case of a lithium ion battery in which internal resistances on a positive electrode side and a negative electrode side hardly vary, the circuit configuration of the impedance measuring device 5 may be simplified. For example, the alternating current adjustment unit 540 may be omitted and the alternating currents I1 and I2 matched in amplitude and phase are fixedly output from the power supply units 531 and 532. Further, one of the detection units 521 and 522 is omitted, the internal resistance is computed using an alternating-current potential difference (e.g. alternating-current potential difference V1) detected only by the other detection unit (e.g. positive-electrode side detection unit 521) and an alternating current (e.g. alternating current I1) generating that alternating-current potential difference. Even with such a circuit configuration, effects similar to those of the above embodiments can be obtained.

Further, an example in which the intermediate-point terminal 213 is provided in the middle of the internal resistance R of the fuel cell stack 1 and the amplitudes of the alternating currents I1 and I2 are controlled by the alternating current adjustment unit 540 such that the amplitudes of the alternating-current potential differences V1 and V2 have the same reference value Vs has been described in the present embodiments. However, the intermediate-point terminal 213 may be provided on the power generation cell 10 deviated from the power generation cell 10 located in the middle of the fuel cell stack 1. In this case, it is sufficient to match the alternating-current potential generated at the positive electrode terminal 211 and the alternating-current potential generated at the negative electrode terminal. Thus, a resistance ratio of the internal resistances R1 and R2 is computed depending on the position of the power generation cell 10 provided with the intermediate-point terminal 213 and the reference values of the amplitudes of the alternating-current potential differences V1 and V2 may be set in accordance with that resistance ratio.

It should be noted that the above embodiments can be combined as appropriate.

## Claims

1. A diagnosis device for diagnosing a measurement state of a device (5) configured to measure an impedance of a laminated battery (1), said diagnosis device comprising:

   a power supply unit (531,532) configured to output an alternating current for measuring an impedance of the laminated battery (1) to a positive electrode and a negative electrode of the laminated battery (1), a plurality of battery cells being laminated in the laminated battery (1);
   a detection unit (521,522) configured to detect at least one of an alternating-current potential difference between the positive electrode and an intermediate point (213) of the laminated battery (1) and an alternating-current potential difference between the negative electrode and the intermediate point (213);
   a computation unit (550) configured to compute the impedance of the laminated battery (1) on the basis of the alternating-current potential difference detected by the detection unit (521,522) and the alternating current output from the power supply unit (531,532); and
   a diagnosis element (561,562) having a predetermined impedance reference value and necessary to calculate a measurement error of the impedance,
   **characterized by**
   a switch unit (570) configured to alternately switch a battery connection state for connecting the power supply unit (531,532) and the detection unit (521,522) to the laminated battery (1) and a diagnosis element connection state for cutting off connection to the laminated battery (1) and connecting the power supply unit (531,532) and the detection unit (521,522) to the diagnosis element (561,562),
   wherein the computation unit (550) is adapted to, when the switch unit (570) is switched to the diagnosis element connection state, measure an impedance of the diagnosis element, calculate a difference between a measurement value of the impedance of the diagnosis element and the impedance reference value as a measurement error and diagnose a measurement state of the device (5) on the basis of the measurement error.

2. The diagnosis device according to claim 1, further comprising:

a first direct current shut-off unit (511 A) connected between the positive electrode of the laminated battery (1) and the power supply unit (531); and
a second direct current shut-off unit (511B) connected between the positive electrode of the laminated battery (1) and the detection unit (521),

wherein the switch unit (570) includes:

a first switcher (571) connected between the first direct current shut-off unit (511 A) and the power supply unit (531) and configured to switch a connection destination of the power supply unit (531) from the first direct current shut-off unit (511 A) to one end of the diagnosis element (561) in the battery connection state; and
a second switcher (573) connected between the second direct current shut-off unit (511B) and a positive-electrode side first terminal of the detection unit (521) and configured to switch a connection destination of the positive-electrode side first terminal of the detection unit (521) from the second direct current shut-off unit (511B) to the one end of the diagnosis element (561) in the battery connection state; and the battery cell located at an intermediate position between the positive electrode and the negative electrode of the laminated battery (1) is connected as the intermediate point (213) to the other end of the diagnosis element (561) and a positive-electrode side second terminal of the detection unit (521) and grounded.

3. The diagnosis device according to claim 2, further comprising:

a third direct current shut-off unit (512A) connected between the negative electrode of the laminated battery (1) and the power supply unit (532); and
a fourth direct current shut-off unit (512B) connected between the negative electrode of the laminated battery (1) and the detection unit (522),

wherein the switch unit (570) includes:

a third switcher (572) connected between the third direct current shut-off unit (512A) and the power supply unit (532) and configured to switch the connection destination of the power supply unit (532) from the third direct current shut-off unit (512A) to the one end of the diagnosis element (562) in the battery connection state; and
a fourth switcher (574) connected between the fourth direct current shut-off unit (512B) and a negative-electrode side first terminal of the detection unit (522) and configured to switch a connection destination of the negative-electrode side first terminal of the detection unit (522) from the fourth direct current shut-off unit (512B) to the one end of the diagnosis element (562) in the battery connection state; and the battery cell located at the intermediate position of the laminated battery (1) is connected as the intermediate point (213) to the other end of the diagnosis element (562) and a negative-electrode side second terminal of the detection unit (522) and grounded.

4. The diagnosis device according to any one of claims 1 to 3, further comprising
a filter (5211,5221) configured to extract the same frequency component as the alternating current from an alternating-current potential signal output from the positive electrode or negative electrode of the laminated battery (1), wherein the filter (5211,5221) is connected between the switch unit (570) and the detection unit (521,522).

5. The diagnosis device according to any one of claims 1 to 4, further comprising
adjustment unit (540) configured to adjust an amplitude of the alternating current output from the power supply unit (531,532) such that the alternating-current potential difference between the positive electrode and the intermediate point (213) and the alternating-current potential difference between the negative electrode and the intermediate point (213) coincide, wherein the impedance of the diagnosis element (561,562) is set at a value in a variation range of the impedance of the laminated battery (1) as the impedance reference value.

6. The diagnosis device according to any one of claims 1 to 5, wherein the diagnosis element (561,562) is configured by using any of a resistance element, a capacitor element and an inductor element.

7. The diagnosis device according to any one of claims 1 to 6, wherein the computation unit (550) is further adapted to compute the impedance of the diagnosis element on the basis of the alternating-current potential difference detected by the detection unit (521,522) and the alternating current output from the power supply unit (531,532) when the switch unit (570) is switched to the diagnosis element connection state, and diagnose that the measurement state is bad when a difference between the impedance and the impedance reference value exceeds a prescribed threshold value.

8. The diagnosis device according to any one of claims 1 to 7, wherein:

   a plurality of the diagnosis elements (561,562) having mutually different impedance reference values are provided; and
   the computation unit (550) is further adapted to:

   compute a correction coefficient for correcting each of measurement errors of the plurality of diagnosis elements (561,562) according to the impedance of the laminated battery (1) on the basis of the measurement errors when the switch unit (570) is switched to the diagnosis element connection state;
   compute the impedance of the laminated battery (1); and
   correct the impedance on the basis of the correction coefficient when the switch unit (570) is switched to the battery connection state.

9. The diagnosis device according to any one of claims 1 to 8, wherein:

   the computation unit (550) is further adapted to switch the switch unit (570) to the diagnosis element connection state and compute the impedance of the diagnosis element (561,562) when the diagnosis device is manufactured, started or stopped.

10. The diagnosis device according to any one of claims 1 to 9, further comprising a switch (61) operable from outside, wherein:

    the computation unit (550) is further adapted to switch the switch unit (570) to the diagnosis element connection state according to the operation of the switch (61) and
    compute the impedance of the diagnosis element (561,562).

11. The diagnosis device according to any one of claims 1 to 10, wherein:

    the laminated battery (1) is a fuel cell (1);
    the diagnosis device is connected to a control device (6) configured to control a fuel cell system;
    the control device (6) is further adapted to transmit a command signal for correcting the impedance of the laminated battery (1) to the computation unit (550) when a frequency of the alternating current output from the power supply unit (531,532) is changed or according to a power generation state of the fuel cell (1); and
    the computation unit (550) is further adapted to switch the switch unit (570) to the diagnosis element connection state and calculate a measurement error of the diagnosis element (561,562) when receiving the command signal from the control device (6).

12. The diagnosis device according to any one of claims1 to 11, wherein:

    the computation unit (550) is further adapted to switch the switch unit (570) to the diagnosis element connection state and calculate a measurement error of the diagnosis element (561,562) according to a temperature of the laminated battery (1) or an ambient temperature.

13. A diagnosis method implemented in a diagnosis device according to any of claims 1 to 12 for diagnosing a measurement state of a device (5) configured to measure an impedance of a laminated battery (1), said method comprising:

    switching the switch unit (570) to the diagnosis element connection state;
    measuring an impedance of the diagnosis element (561,562);
    calculating a difference between a measurement value of the impedance of the diagnosis element (561,562) and the impedance reference value as a measurement error; and
diagnosing a measurement state of the device (5) on the basis of the measurement error.

**Patentansprüche**

1. Diagnosevorrichtung zum Diagnostizieren eines Messungs-Zustandes einer Vorrichtung (5), die zum Messen einer Impedanz einer geschichteten Batterie (1) ausgeführt ist, wobei die Diagnosevorrichtung umfasst:

   eine Stromversorgungs-Einheit (531, 532), die so ausgeführt ist, dass sie einen Wechselstrom zum Messen einer Impedanz der geschichteten Batterie (1) an eine positive Elektrode und eine negative Elektrode der geschichteten Batterie (1) ausgibt, wobei in der geschichteten Batterie (1) eine Vielzahl von Batteriezellen geschichtet sind;
   eine Erfassungs-Einheit (521, 522), die so ausgeführt ist, dass sie eine Wechselstrom-Potenzialdifferenz zwischen der positiven Elektrode und einem Zwischenpunkt (213) der geschichteten Batterie oder/und eine Wechselstrom-Potenzialdifferenz zwischen der negativen Elektrode und dem Zwischenpunkt (213) erfasst;
   eine Berechnungs-Einheit (550), die so ausgeführt ist, dass sie die Impedanz der geschichteten Batterie (1) auf Basis der durch die Erfassungs-Einheit (521, 522) erfassten Wechselstrom-Potenzialdifferenz und des von der Stromversorgungs-Einheit (531, 532) ausgegebenen Wechselstroms berechnet; sowie
   ein Diagnose-Element (561, 562), das einen vorgegebenen Impedanz-Bezugswert hat und erforderlich ist, um einen Messfehler der Impedanz zu berechnen,
   **gekennzeichnet durch**
   eine Schalt-Einheit (570), die so ausgeführt ist, dass sie abwechselnd einen Batterie-Verbindungszustand, in dem die Stromversorgungs-Einheit (531, 532) und die Erfassungs-Einheit (521, 522) mit der geschichteten Batterie (1) verbunden sind, und einen Diagnose-Element-Verbindungszustand schaltet, in dem Verbindung zu der geschichteten Batterie (1) unterbrochen ist und die Stromversorgungs-Einheit (531, 532) sowie die Erfassungs-Einheit (521, 522) mit dem Diagnose-Element (561, 562) verbunden sind,
   wobei die Berechnungs-Einheit (550) so eingerichtet ist, dass sie, wenn die Schalt-Einheit (570) in den Diagnose-Element-Verbindungszustand geschaltet ist, eine Impedanz des Diagnose-Elementes misst, eine Differenz zwischen einem Messwert der Impedanz des Diagnose-Elementes und dem Impedanz-Bezugswert als einen Messfehler berechnet und einen Messungs-Zustand der Vorrichtung (5) auf Basis des Messfehlers diagnostiziert.

2. Diagnosevorrichtung nach Anspruch 1, die des Weiteren umfasst:

   eine erste Gleichstrom-Abschalt-Einheit (511A), die zwischen die positive Elektrode der geschichteten Batterie (1) und die Stromversorgungs-Einheit (531) geschaltet ist; sowie
   eine zweite Gleichstrom-Abschalt-Einheit (511B), die zwischen die positive Elektrode der geschichteten Batterie (1) und die Erfassungs-Einheit (521) geschaltet ist,
   wobei die Schalt-Einheit (570) enthält:

   eine erste Umschalteinrichtung (571), die zwischen die erste Gleichstrom-Abschalt-Einheit (511A) und die Stromversorgungs-Einheit (531) geschaltet und so ausgeführt ist, dass sie in dem Batterie-Verbindungszustand ein Verbindungs-Ziel der Stromversorgungs-Einheit (531) von der ersten Gleichstrom-Abschalt-Einheit (511A) zu einem Ende des Diagnose-Elementes (561) umschaltet; sowie
   eine zweite Umschalteinrichtung (573), die zwischen die zweite Gleichstrom-Abschalt-Einheit (511B) und einen ersten Anschluss an der Seite der positiven Elektrode der Erfassungs-Einheit (521) geschaltet und so ausgeführt ist, dass sie in dem Batterie-Verbindungszustand ein Verbindungs-Ziel des ersten Anschlusses an der Seite der positiven Elektrode der Erfassungs-Einheit (521) von der zweiten Gleichstrom-Abschalt-Einheit (511B) zu dem einen Ende des Diagnose-Elementes (561) umschaltet, und die an dem Zwischenpunkt zwischen der positiven Elektrode und der negativen Elektrode der geschichteten Batterie (1) befindliche Batteriezelle als der Zwischenpunkt (213) mit dem anderen Ende des Diagnose-Elementes (561) und einem zweiten Anschluss an der Seite der positiven Elektrode der Erfassungs-Einheit (521) verbunden und geerdet ist.

3. Diagnosevorrichtung nach Anspruch 2, die des Weiteren umfasst:

   eine dritte Gleichstrom-Abschalt-Einheit (512A), die zwischen die negative Elektrode der geschichteten Batterie (1) und die Stromversorgungs-Einheit (532) geschaltet ist; sowie
eine vierte Gleichstrom-Abschalt-Einheit (512B), die zwischen die negative Elektrode der geschichteten Batterie (1) und die Erfassungs-Einheit (522) geschaltet ist,
wobei die Schalt-Einheit (570) enthält:

eine dritte Umschalteinrichtung (572), die zwischen die dritte Gleichstrom-Abschalt-Einheit (512A) und die Stromversorgungs-Einheit (532) geschaltet und so ausgeführt ist, dass sie in dem Batterie-Verbindungszustand das Verbindungs-Ziel der Stromversorgungs-Einheit (532) von der dritten Gleichstrom-Abschalt-Einheit (512A) zu dem einen Ende des Diagnose-Elementes (562) umschaltet; sowie
eine vierte Umschalteinrichtung (574), die zwischen die vierte Gleichstrom-Abschalt-Einheit (512B) und einen ersten Anschluss an der Seite der negativen Elektrode der Erfassungs-Einheit (522) geschaltet und so ausgeführt ist, dass sie in dem Batterie-Verbindungszustand ein Verbindungs-Ziel des ersten Anschlusses an der Seite der negativen Elektrode der Erfassungs-Einheit (522) von der vierten Gleichstrom-Abschalt-Einheit (512B) zu dem einen Ende des Diagnose-Elementes (562) umschaltet, und die an dem Zwischenpunkt der geschichteten Batterie (1) befindliche Batteriezelle als der Zwischenpunkt (213) mit dem anderen Ende des Diagnose-Elementes (562) und einem zweiten Anschluss an der Seite der negativen Elektrode der Erfassungs-Einheit (522) verbunden und geerdet ist.

4. Diagnosevorrichtung nach einem der Ansprüche 1 bis 3, die des Weiteren
ein Filter (5211, 5221) umfasst, das so ausgeführt ist, dass es die gleiche Frequenzkomponente wie in dem Wechselstrom aus einem Wechselstrom-Potenzial-Signal extrahiert, das von der positiven Elektrode oder der negativen Elektrode der geschichteten Batterie (1) ausgegeben wird,
wobei das Filter (5211, 5221) zwischen die Schalt-Einheit (570) und die Erfassungs-Einheit (521, 522) geschaltet ist.

5. Diagnosevorrichtung nach einem der Ansprüche 1 bis 4, die des Weiteren
eine Anpassungs-Einheit (540) umfasst, die so ausgeführt ist, dass sie eine Amplitude des von der Stromversorgungs-Einheit (531, 532) ausgegebenen Wechselstroms so anpasst, dass die Wechselstrom-Potenzialdifferenz zwischen der positiven Elektrode und dem Zwischenpunkt (213) und die Wechselstrom-Potenzialdifferenz zwischen der negativen Elektrode und dem Zwischenpunkt (213) übereinstimmen,
wobei die Impedanz des Diagnose-Elementes (561, 562 auf einen Wert in einem Variationsbereich der Impedanz der beschichteten Batterie (1) als dem Impedanz-Bezugswert eingestellt wird.

6. Diagnosevorrichtung nach einem der Ansprüche 1 bis 5, wobei das Diagnose-Element (561, 562) unter Verwendung eines Widerstands-Elementes, eines Kondensator-Elementes oder eines Induktivitäts-Elementes ausgeführt wird.

7. Diagnosevorrichtung nach einem der Ansprüche 1 bis 6, wobei die Berechnungs-Einheit (550) des Weiteren so eingerichtet ist, dass sie die Impedanz des Diagnose-Elementes auf Basis der durch die Erfassungs-Einheit (521, 522) erfassten Wechselstrom-Potenzialdifferenz und des von der Stromversorgungs-Einheit (531, 532) ausgegebenen Wechselstroms berechnet, wenn die Schalt-Einheit (570) in den Diagnoseelement-Verbindungszustand geschaltet ist, und diagnostiziert, dass der Messungs-Zustand mangelhaft ist, wenn eine Differenz zwischen der Impedanz und dem Impedanz-Bezugswert einen vorgeschriebenen Schwellenwert überschreitet.

8. Diagnosevorrichtung nach einem der Ansprüche 1 bis 7, wobei:

eine Vielzahl der Diagnose-Elemente (561, 562) vorhanden sind, die voneinander verschiedene Impedanz-Bezugswerte haben; und
die Berechnungs-Einheit (550) des Weiteren so eingerichtet ist, dass sie
einen Korrektur-Koeffizienten zum Korrigieren jedes der Messfehler der Vielzahl von Diagnose-Elementen (561, 562) entsprechend der Impedanz der geschichteten Batterie (1) auf Basis der Messfehler berechnet, wenn die Schalt-Einheit (570) in den Diagnoseelement-Verbindungszustand geschaltet ist;
die Impedanz der geschichteten Batterie (1) berechnet; und
Die Impedanz auf Basis des Korrektur-Koeffizienten korrigiert, wenn die Schalt-Einheit (570) in den Batterie-Verbindungszustand geschaltet ist.

9. Diagnosevorrichtung nach einem der Ansprüche 1 bis 8, wobei:

die Berechnungs-Einheit (550) des Weiteren so eingerichtet ist, dass sie die Schalt-Einheit (570) in den Diagnoseelement-Verbindungszustand schaltet und die Impedanz des Diagnose-Elementes (561, 562) berechnet, wenn die Diagnosevorrichtung hergestellt, in Gang gesetzt oder angehalten wird.

10. Diagnosevorrichtung nach einem der Ansprüche 1 bis 9, die des Weiteren einen Schalter (61) umfasst, der von außen betätigt werden kann, wobei:

die Berechnungs-Einheit (550) des Weiteren so eingerichtet ist, dass sie die Schalt-Einheit (570) entsprechend der Betätigung des Schalters (61) in den Diagnoseelement-Verbindungszustand schaltet und die Impedanz des Diagnose-Elementes (561, 562) berechnet.

11. Diagnosevorrichtung nach einem der Ansprüche 1 bis 10, wobei::

die geschichtete Batterie (1) eine Brennstoffzelle (1) ist;
die Diagnosevorrichtung mit einer Steuerungsvorrichtung (6) verbunden ist, die so ausgeführt ist, dass sie ein Brennstoffzellen-System steuert;
die Steuerungsvorrichtung (6) des Weiteren so eingerichtet ist, dass sie bei Änderung einer Frequenz des von der Stromversorgungs-Einheit (531, 532) ausgegebenen Wechselstroms oder entsprechend einem Energieerzeugungs-Zustand der Brennstoffzelle (1) ein Befehls-Signal zum Korrigieren der Impedanz der geschichteten Batterie (1) zu der Berechnungs-Einheit (550) sendet; und
die Berechnungs-Einheit (550) des Weiteren so eingerichtet ist, dass sie die Schalt-Einheit (570) in den Diagnoseelement-Verbindungszustand schaltet und einen Messfehler des Diagnose-Elementes (561, 562) berechnet, wenn sie das Befehls-Signal von der Steuerungsvorrichtung (6) empfängt.

12. Diagnosevorrichtung nach einem der Ansprüche 1 bis 11, wobei:

die Berechnungs-Einheit (550) des Weiteren so eingerichtet ist, dass sie die Schalt-Einheit (570) in den Diagnoseelement-Verbindungszustand schaltet und einen Messfehler des Diagnose-Elementes (561, 562) entsprechend einer Temperatur der geschichteten Batterie (1) oder einer Umgebungstemperatur berechnet.

13. Diagnoseverfahren, das in einer Diagnosevorrichtung nach einem der Ansprüche 1 bis 12 umgesetzt wird, um einen Messungs-Zustand einer Vorrichtung (5) zu diagnostizieren, die zum Messen einer Impedanz einer geschichteten Batterie (1) ausgeführt ist, wobei das Verfahren umfasst:

Schalten der Schalt-Einheit (570) in den Diagnoseelement-Verbindungszustand;
Messen einer Impedanz des Diagnose-Elementes (561, 562);
Berechnen einer Differenz zwischen einem Messwert der Impedanz des Diagnose-Elementes (561, 562) und dem Impedanz-Bezugswert als einen Messfehler; sowie
Diagnostizieren eines Messungs-Zustandes der Vorrichtung (5) auf Basis des Messfehlers.

**Revendications**

1. Dispositif de diagnostic pour diagnostiquer un état de mesure d'un dispositif (5) configuré pour mesurer une impédance d'une batterie laminée (1), ledit dispositif de diagnostic comprenant :

une unité d'alimentation électrique (531, 532) configurée pour délivrer en sortie un courant alternatif destiné à mesurer une impédance de la batterie laminée (1) dans une électrode positive et une électrode négative de la batterie laminée (1), une pluralité de cellules de batterie étant laminées dans la batterie laminée (1) ;
une unité de détection (521,522) configurée pour détecter au moins l'une parmi une différence de potentiel en courant alternatif entre l'électrode positive et un point intermédiaire (213) de la batterie laminée (1) et une différence de potentiel en courant alternatif entre l'électrode négative et le point intermédiaire (213) ;
une unité de calcul (550) configurée pour calculer l'impédance de la batterie laminée (1) sur la base de la différence de potentiel en courant alternatif détectée par l'unité de détection (521, 522) et du courant alternatif délivré en sortie par l'unité d'alimentation électrique (531, 532) ; et
un élément de diagnostic (561, 562) ayant une valeur de référence d'impédance prédéterminée et nécessaire pour calculer une erreur de mesure de l'impédance, **caractérisé par**
une unité de commutation (570) configurée pour commuter en alternance un état de connexion de batterie pour connecter l'unité d'alimentation électrique (531, 532) et l'unité de détection (521, 522) à la batterie laminée (1) et un état de connexion d'élément de diagnostic pour couper la connexion à la batterie laminée (1) et connecter l'unité d'alimentation électrique (531, 532) et l'unité de détection (521, 522) à l'élément de diagnostic (561, 562), dans lequel l'unité de calcul (550) est adaptée pour, lorsque l'unité de commutation (570) est commutée dans l'état de connexion d'élément de diagnostic, mesurer une impédance de l'élément de diagnostic, calculer une différence entre une valeur de mesure de l'impédance de l'élément de diagnostic et la valeur de référence d'impédance en tant qu'erreur de mesure et diagnostiquer un état de mesure du dispositif (5) sur la base de l'erreur de mesure.

2. Dispositif de diagnostic selon la revendication 1, comprenant en outre :

une première unité de coupure de courant continu (511A) connectée entre l'électrode positive de la batterie laminée (1) et l'unité d'alimentation électrique (531) ; et
une deuxième unité de coupure de courant continu (511B) connectée entre l'électrode positive de la batterie laminée (1) et l'unité de détection (521),

dans lequel l'unité de commutation (570) comprend :

un premier commutateur (571) connecté entre la première unité de coupure de courant continu (511A) et l'unité d'alimentation électrique (531) et configuré pour commuter une destination de connexion de l'unité d'alimentation électrique (531) de la première unité de coupure de courant continu (511A) vers une première extrémité de l'élément de diagnostic (561) dans l'état de connexion de batterie ; et
un deuxième commutateur (573) connecté entre la deuxième unité de coupure de courant continu (511B) et une première borne côté électrode positive de l'unité de détection (521) et configuré pour commuter une destination de connexion de la première borne côté électrode positive de l'unité de détection (521) depuis la deuxième unité de coupure de courant continu (511B) vers la première extrémité de l'élément de diagnostic (561) dans l'état de connexion de la batterie ; et la cellule de batterie située dans une position intermédiaire entre l'électrode positive et l'électrode négative de la batterie laminée (1) est connectée en tant que le point intermédiaire (213) à l'autre extrémité de l'élément de diagnostic (561) et à une seconde borne côté électrode positive de l'unité de détection (521) et mise à la terre.

3. Dispositif de diagnostic selon la revendication 2, comprenant en outre :

une troisième unité de coupure de courant continu (512A) connectée entre l'électrode négative de la batterie laminée (1) et l'unité d'alimentation électrique (532) ; et
une quatrième unité de coupure de courant continu (512B) connectée entre l'électrode négative de la batterie laminée (1) et l'unité de détection (522),

dans lequel l'unité de commutation (570) comprend :

un troisième commutateur (572) connecté entre la troisième unité de coupure de courant continu (512A) et l'unité d'alimentation électrique (532) et configuré pour commuter la destination de connexion de l'unité d'alimentation électrique (532) depuis la troisième unité de coupure de courant continu (512A) vers la première extrémité de l'élément de diagnostic (562) dans l'état de connexion de batterie ; et
un quatrième commutateur (574) connecté entre la quatrième unité de coupure de courant continu (512B) et une première borne côté électrode négative de l'unité de détection (522) et configuré pour commuter une destination de connexion de la première borne côté électrode négative de l'unité de détection (522) depuis la quatrième unité de coupure de courant continu (512B) vers la première extrémité de l'élément de diagnostic (562) dans l'état de connexion de batterie ; et la cellule de batterie située dans la position intermédiaire de la batterie laminée (1) est connectée en tant que le point intermédiaire (213) à l'autre extrémité de l'élément de diagnostic (562) et à une seconde borne côté électrode négative de l'unité de détection (522) et mise à la terre.

4. Dispositif de diagnostic selon l'une quelconque des revendications 1 à 3, comprenant en outre un filtre (5211, 5221) configuré pour extraire la même composante de fréquence que le courant alternatif à partir d'un signal de potentiel en courant alternatif délivré en sortie par l'électrode positive ou l'électrode négative de la batterie laminée (1),
dans lequel le filtre (5211, 5221) est connecté entre l'unité de commutation (570) et l'unité de détection (521, 522).

5. Dispositif de diagnostic selon l'une quelconque des revendications 1 à 4, comprenant en outre une unité d'ajustement (540) configurée pour ajuster une amplitude du courant alternatif délivré en sortie par l'unité d'alimentation électrique (531, 532) de sorte que la différence de potentiel en courant alternatif entre l'électrode positive et le point intermédiaire (213) et la différence de potentiel en courant alternatif entre l'électrode négative et le point intermédiaire (213) coïncident,

dans lequel l'impédance de l'élément de diagnostic (561, 562) est établie à une valeur dans une plage de variation de l'impédance de la batterie laminée (1) en tant que valeur de référence d'impédance.

6. Dispositif de diagnostic selon l'une quelconque des revendications 1 à 5, dans lequel l'élément de diagnostic (561, 562) est configuré en utilisant l'un quelconque parmi un élément de résistance, un élément condensateur et un élément inducteur.

7. Dispositif de diagnostic selon l'une quelconque des revendications 1 à 6, dans lequel l'unité de calcul (550) est en outre adaptée pour calculer l'impédance de l'élément de diagnostic sur la base de la différence de potentiel en courant alternatif détectée par l'unité de détection (521, 522) et le courant alternatif délivré en sortie de l'unité d'alimentation électrique (531, 532) lorsque l'unité de commutation (570) est commutée vers l'état de connexion d'élément de diagnostic, et diagnostiquer que l'état de mesure est mauvais lorsqu'une différence entre l'impédance et la valeur de référence d'impédance dépasse une valeur de seuil prescrite.

8. Dispositif de diagnostic selon l'une quelconque des revendications 1 à 7, dans lequel :

une pluralité des éléments de diagnostic (561, 562) ayant des valeurs de référence d'impédance mutuellement différentes sont fournis ; et
l'unité de calcul (550) est en outre adaptée pour :

calculer un coefficient de correction pour corriger chacune des erreurs de mesure de la pluralité d'éléments de diagnostic (561, 562) en fonction de l'impédance de la batterie laminée (1) sur la base des erreurs de mesure lorsque l'unité de commutation (570) est commutée vers l'état de connexion d'élément de diagnostic ;
calculer l'impédance de la batterie laminée (1) ; et
corriger l'impédance sur la base du coefficient de correction lorsque l'unité de commutation (570) est commutée vers l'état de connexion de batterie.

9. Dispositif de diagnostic selon l'une quelconque des revendications 1 à 8, dans lequel :

l'unité de calcul (550) est en outre adaptée pour commuter l'unité de commutation (570) vers l'état de connexion d'élément de diagnostic et calculer l'impédance de l'élément de diagnostic (561,562) lorsque le dispositif de diagnostic est fabriqué, démarré ou arrêté.

10. Dispositif de diagnostic selon l'une quelconque des revendications 1 à 9, comprenant en outre un commutateur (61) actionnable depuis l'extérieur, dans lequel :

l'unité de calcul (550) est en outre adaptée pour commuter l'unité de commutation (570) vers l'état de connexion d'élément de diagnostic en fonction de l'opération du commutateur (61) et calculer l'impédance de l'élément de diagnostic (561,562).

11. Dispositif de diagnostic selon l'une quelconque des revendications 1 à 10, dans lequel :

la batterie laminée (1) est une pile à combustible (1) ;
le dispositif de diagnostic est connecté à un dispositif de commande (6) configuré pour commander un système de pile à combustible ;
le dispositif de commande (6) est en outre adapté pour transmettre un signal d'instruction pour corriger l'impédance de la batterie laminée (1) à l'unité de calcul (550) lorsqu'une fréquence du courant alternatif délivré en sortie par l'unité d'alimentation électrique (531, 532) est modifiée ou en fonction d'un état de production d'énergie de la pile à combustible (1) ; et
l'unité de calcul (550) est en outre adaptée pour commuter l'unité de commutation (570) vers l'état de connexion d'élément de diagnostic et calculer une erreur de mesure de l'élément de diagnostic (561,562) lors de la réception du signal d'instruction provenant du dispositif de commande (6).

12. Dispositif de diagnostic selon l'une quelconque des revendications 1 à 11, dans lequel :

l'unité de calcul (550) est en outre adaptée pour commuter l'unité de commutation (570) vers l'état de connexion d'élément de diagnostic et calculer une erreur de mesure de l'élément de diagnostic (561, 562) en fonction d'une température de la batterie laminée (1) ou d'une température ambiante.

13. Procédé de diagnostic implémenté dans un dispositif de diagnostic selon l'une quelconque des revendications 1 à 12 pour diagnostiquer un état de mesure d'un dispositif (5) configuré pour mesurer une impédance d'une batterie laminée (1), ledit procédé comprenant de :

commuter l'unité de commutation (570) vers l'état de connexion d'élément de diagnostic ;
mesurer une impédance de l'élément de diagnostic (561, 562) ;
calculer une différence entre une valeur de mesure de l'impédance de l'élément de diagnostic (561, 562) et la valeur de référence d'impédance en tant qu'erreur de mesure ; et
diagnostiquer un état de mesure du dispositif (5) sur la base de l'erreur de mesure.

FIG.1A

FIG.1B

FIG.2

FIG.3

531(532)

TO 511
(512)   Io

Rs

R

R

R

R

R

FROM
540

Vi

GND

FIG.4

FIG.5

FIG.6

START

S1

Va > PREDETERMINED VALUE? No

Yes

S2

Va < PREDETERMINED VALUE? Yes

No

S3

REDUCE OUTPUT OF POSITIVE-ELECTRODE SIDE POWER SUPPLY UNIT 531

S4

MAINTAIN OUTPUT OF POSITIVE-ELECTRODE SIDE POWER SUPPLY UNIT 531 (NOP)

S5

INCREASE OUTPUT OF POSITIVE-ELECTRODE SIDE POWER SUPPLY UNIT 531

S6

Vb > PREDETERMINED VALUE? No

Yes

S7

Vb < PREDETERMINED VALUE? Yes

No

S8

REDUCE OUTPUT OF NEGATIVE-ELECTRODE SIDE POWER SUPPLY UNIT 532

S9

MAINTAIN OUTPUT OF NEGATIVE-ELECTRODE SIDE POWER SUPPLY UNIT 532 (NOP)

S10

INCREASE OUTPUT OF NEGATIVE-ELECTRODE SIDE POWER SUPPLY UNIT 532

S11

BOTH Va AND Vb ARE PREDETERMINED VALUE? Yes

No

S12

COMPUTE RESISTANCE VALUES (OUTPUT)

END

FIG.7

FIG.8

FIG.9

FIG.10

FIG.11

START

S101
DIAGNOSIS TIMING? ──No──┐
│Yes

S102
CONNECT POWER
SUPPLY UNITS TO
DIAGNOSIS ELEMENTS
AND DETECTION UNITS
TO DIAGNOSIS ELEMENTS

S106
CONNECT POWER SUPPLY
UNITS TO LAMINATED
BATTERY AND DETECTION
UNITS TO LAMINATED
BATTERY

S103
MEASURE IMPEDANCES
OF DIAGNOSIS ELEMENTS

S107
MEASURE IMPEDANCE
OF LAMINATED BATTERY

S104
ERRORS OF
MEASUREMENT VALUES
WITHIN ALLOWABLE
ERROR RANGE?
No │ Yes

S108
OUTPUT MEASUREMENT
VALUE OF LAMINATED
BATTERY TO
TRANSMISSION
DESTINATION

S105
OUTPUT DIAGNOSIS
RESULT TO
TRANSMISSION
DESTINATION

S109
No──│ IMPEDANCE
MEASURING
DEVICE OFF?
│Yes

END

FIG.12

FIG.13

FIG.14

FIG.15

FIG.16

START

S201
DIAGNOSIS TIMING? — No
Yes

S202
CONNECT POWER
SUPPLY UNITS TO
DIAGNOSIS ELEMENTS
AND DETECTION UNITS
TO DIAGNOSIS ELEMENTS

S207
CONNECT POWER SUPPLY
UNITS TO LAMINATED
BATTERY AND DETECTION
UNITS TO LAMINATED
BATTERY

S203
MEASURE IMPEDANCE
OF EACH DIAGNOSIS
ELEMENT

S208
MEASURE IMPEDANCE
OF LAMINATED BATTERY

S204
No — ERRORS OF
MEASUREMENT VALUES
WITHIN ALLOWABLE
ERROR RANGE?
Yes

S209
CORRECT MEASUREMENT
VALUES OF LAMINATED
BATTERY ON BASIS OF
CORRECTION
COEFFICIENTS

S205
COMPUTE CORRECTION
COEFFICIENTS ON BASIS
OF PLURAL
MEASUREMENT VALUES

S210
OUTPUT MEASUREMENT
VALUE OF LAMINATED
BATTERY TO
TRANSMISSION
DESTINATION

S206
RECORD CORRECTION
COEFFICIENTS IN
MEMORY

S211
No — IMPEDANCE
MEASURING
DEVICE OFF?
Yes

END

FIG.17

52

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012077450 A
- JP 2005180927 A
- US 2012306506 A1